# EUROPEAN PATENT APPLICATION

(11) **EP 2 913 680 A1**
(43) Date of publication of application: **02.09.2015**
(21) Application number: 15156779.9
(22) Date of filing: 26.02.2015
(51) Int. Cl.: G01P 15/097, G01C 19/5726, G01P 15/125, G01P 15/08

(54) **Electronic device, electronic apparatus, and moving object**

(30) Priority: 28.02.2014 JP 2014038172
(71) Applicant: Seiko Epson Corporation, Tokyo 163 (JP)
(72) Inventor: Kanemoto, Kei, Nagano, 392-8502 (JP)
(74) Representative: Hoffmann Eitle

(57) **Abstract**

A composite sensor includes an angular velocity sensor element, an acceleration sensor element, and a drive circuit adapted to generate a first signal used to excite a vibration of the angular velocity sensor element, and the drive circuit supplies the acceleration sensor element with a second signal based on the first signal.

## Description

### BACKGROUND

### 1. Technical Field

The present invention relates to an electronic device, an electronic apparatus, and a moving object.

### 2. Related Art

There has been known an electronic device provided with a plurality of functional elements (see, e.g., JP-A-2012-122745 (Document 1)). An electronic device (a composite sensor) described in Document 1 is provided with an acceleration sensor (a first detection section) and an angular velocity sensor (a second detection section). The acceleration sensor requires a carrier signal for detecting a capacitance variation, and the angular velocity sensor requires a drive signal for generating a Coriolis force.

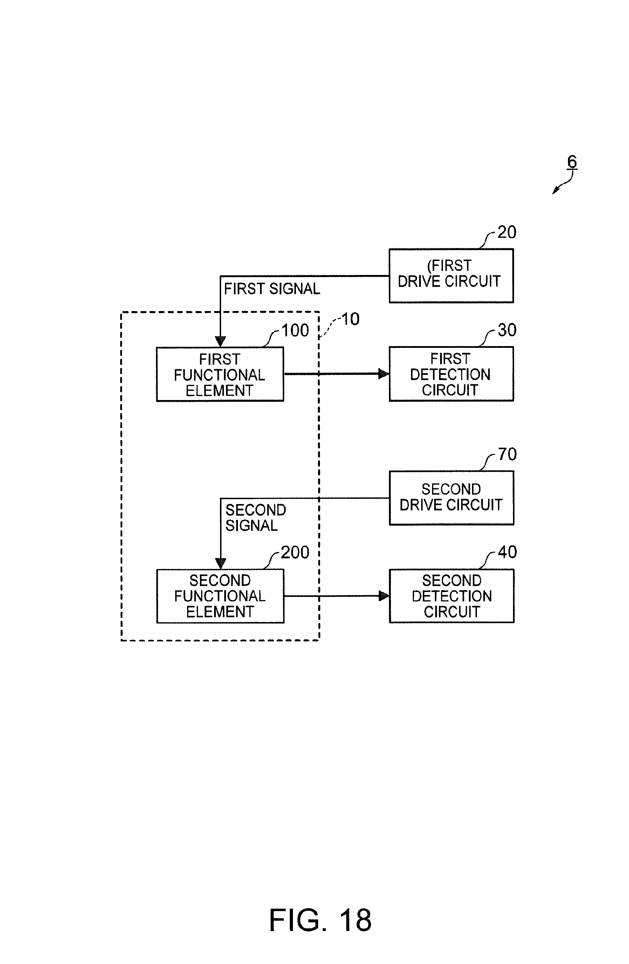

However, in the circuit configuration of the electronic device described in Document 1 (see Fig. 18), a generation section of the carrier signal to be supplied to the acceleration sensor and a generation section of the drive signal to be supplied to the angular velocity sensor are separately disposed. Therefore, there is a problem that miniaturization of the circuit is difficult.

### SUMMARY

The object of the present invention is to solve at least a part of the problems described above. This object is achieved by means of an electronic device, an electronic apparatus, and a moving obj ect as defined in the appended claims. The invention can be implemented as the following aspects or application examples.

### Application Example 1

An electronic device according to this application example includes a first functional element, a second functional element, and a signal generation section adapted to generate a first signal used to excite the first functional element, and the signal generation section supplies the second functional element with a second signal based on the first signal.

According to the configuration of this application example, the electronic device is a composite device provided with the first functional element and the second functional element, and the signal generation section adapted to generate the first signal for exciting the first functional element supplies the second functional element with the second signal based on the first signal. Therefore, the electronic device does not necessarily need the generation section for generating the second signal. Thus, the miniaturization of the circuit in the electronic device becomes possible.

### Application Example 2

In the electronic device according to the application example described above, it is preferable that the electronic device further includes an adjustment section adapted to adjust the first signal to form the second signal and disposed between the signal generation section and the second functional element.

According to the configuration of this application example, the first signal generated by the signal generation section is adjusted by the adjustment section to form the second signal. Therefore, it is possible to adjust the first signal to thereby make the second signal suitable for the second functional element.

### Application Example 3

In the electronic device according to the application example described above, it is preferable that the adjustment section includes at least one of a frequency multiplier and a frequency divider adapted to adjust a frequency of the first signal.

According to the configuration of this application example, it is possible to adjust (increase or decrease) the frequency of the first signal using the adjustment section to supply the second signal with the frequency suitable for the second functional element.

### Application Example 4

In the electronic device according to the application example described above, it is preferable that the adjustment section includes an amplitude adjustment section adapted to adjust an amplitude of the first signal.

According to the configuration of this application example, it is possible to adjust the amplitude of the first signal using the adjustment section to supply the second signal with the amplitude suitable for the second functional element.

### Application Example 5

In the electronic device according to the application example described above, the first functional element may be an angular velocity sensor element, and the second functional element may be an acceleration sensor element.

According to the configuration of this application example, the composite electronic device provided with the angular velocity sensor for detecting the angular velocity and the acceleration sensor element for detecting the acceleration can be provided.

### Application Example 6

In the electronic device according to the application example described above, the second signal may be different in frequency from the first signal.

According to the configuration of this application example, by making the frequency of the second signal different from the frequency of the first signal, the resonance of the second functional element can be reduced.

### Application Example 7

In the electronic device according to the application example described above, the first signal may be a sinusoidal wave.

According to the configuration of this application example, by adopting the sinusoidal wave as the first signal, the noise due to the harmonic can be reduced in the first signal and the second signal based on the first signal.

### Application Example 8

In the electronic device according to the application example described above, it is preferable that the electronic device further includes a third functional element, and the third functional element is supplied with a third signal based on at least one of the first signal and the second signal.

According to the configuration of this application example, since the generation section for generating the third signal to be supplied to the third functional element is not additionally required, the miniaturization of the circuit and the reduction of the current consumption in the electronic device become possible.

### Application Example 9

An electronic apparatus according to this application example includes the electronic device according to any one of the application examples described above.

According to the configuration of this application example, since the electronic apparatus is equipped with the electronic device according to any one of the application examples described above, the miniaturization and the reduction of the current consumption become possible.

### Application Example 10

A moving object according to this application example includes the electronic device according to any one of the application examples described above.

According to the configuration of this present application example, since the moving object is equipped with the electronic device according to any one of the application examples described above, the miniaturization and the reduction of the current consumption become possible.

### BRIEF DESCRIPTION OF THE DRAWINGS

The invention will be described with reference to the accompanying drawings, wherein like numbers reference like elements.
Fig. 1 is a block diagram showing a schematic configuration of a composite sensor according to a first embodiment of the invention.
Figs. 2A and 2B are diagrams schematically showing a sensor element section of the composite sensor according to the first embodiment.
Fig. 3 is a plan view schematically showing an angular velocity sensor element according to the first embodiment.
Fig. 4 is a cross-sectional view schematically showing the angular velocity sensor element according to the first embodiment.
Fig. 5 is a plan view schematically showing an acceleration sensor element according to the first embodiment.
Fig. 6 is a cross-sectional view schematically showing the acceleration sensor element according to the first embodiment.
Fig. 7 is a block diagram showing a schematic configuration of a composite sensor according to a second embodiment of the invention.
Fig. 8 is a block diagram showing a schematic configuration of a composite sensor according to a third embodiment of the invention.
Fig. 9 is a plan view schematically showing a sensor element section of the composite sensor according to the third embodiment.
Figs. 10A and 10B are perspective views each schematically showing an electronic apparatus according to a fourth embodiment of the invention.
Fig. 11 is a perspective view schematically showing an electronic apparatus according to the fourth embodiment.
Fig. 12 is a perspective view schematically showing a moving object according to a fifth embodiment of the invention.
Fig. 13 is a schematic plan view showing a configuration of an angular velocity sensor element as a first functional element of a composite sensor according to Modified Example 1.
Fig. 14 is a schematic plan view showing a configuration of an angular velocity sensor element as a second functional element of the composite sensor according to Modified Example 1.
Fig. 15 is a schematic plan view showing a configuration of an angular velocity sensor element as a third functional element of the composite sensor according to Modified Example 1.
Fig. 16 is a schematic plan view showing a configuration of an acceleration sensor element as a second functional element of a composite sensor according to Modified Example 2.
Fig. 17 is a schematic plan view showing a configuration of an acceleration sensor element as a third functional element of the composite sensor according to Modified Example 2.
Fig. 18 is a block diagram showing an example of a schematic configuration of a composite sensor of the related art.

### DESCRIPTION OF EXEMPLARY EMBODIMENTS

Some embodiments in which the invention is put into practice will hereinafter be explained with reference to the accompanying drawings. The drawings to be used are shown with appropriate expansion, contraction, or exaggeration so that parts to be explained become in a recognizable state. Further, in some cases, those other than the constituents necessary for the explanation will be omitted from the graphical description.

### First Embodiment

### Basic Configuration of Electronic Device

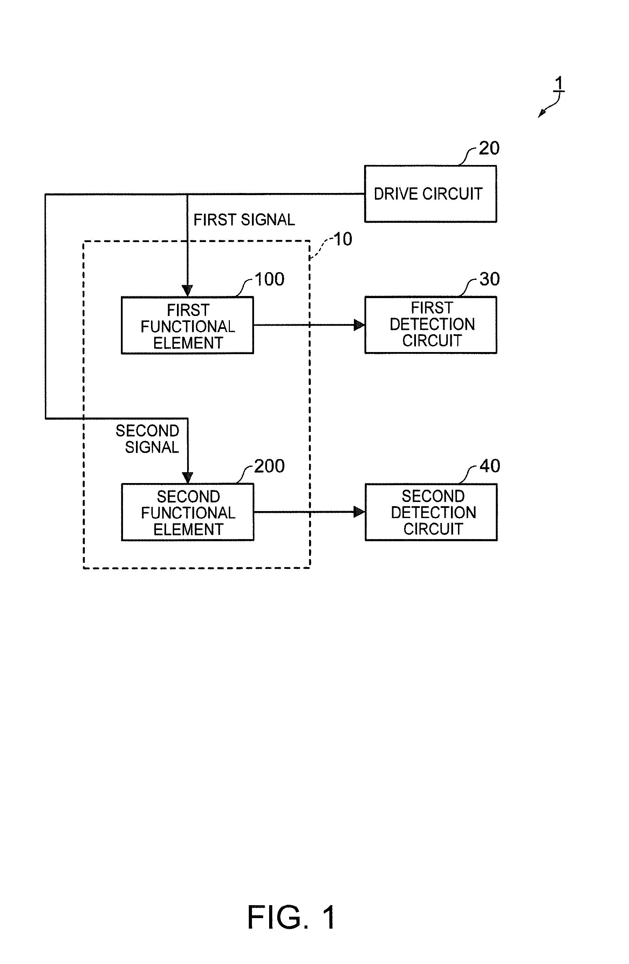

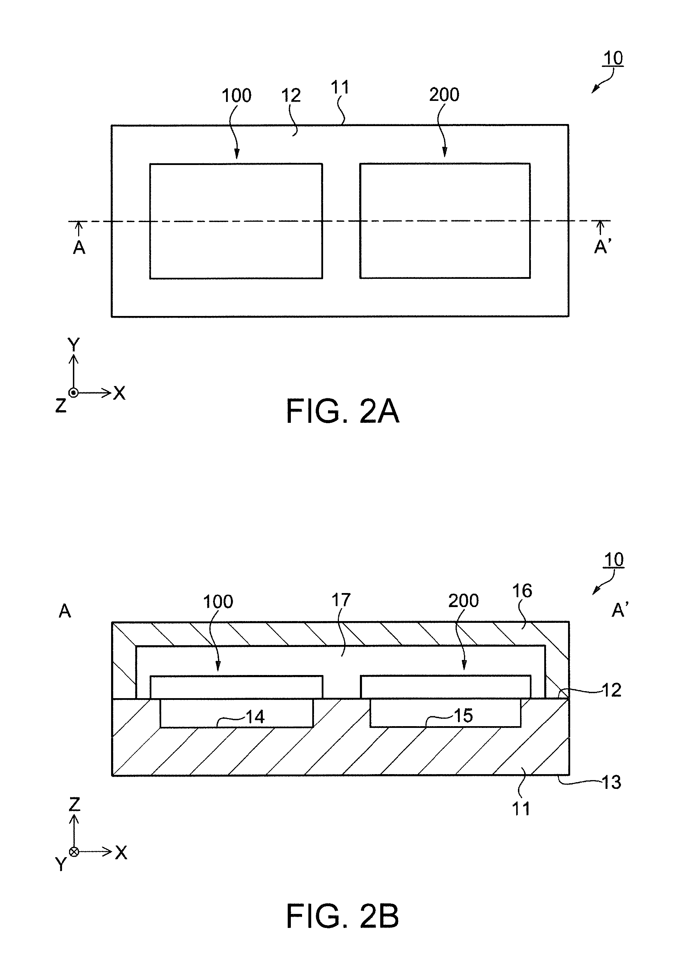

The basic configuration of a composite sensor as an electronic device according to the first embodiment will be explained with reference to Figs. 1, 2A, and 2B. Fig. 1 is a block diagram showing a schematic configuration of the composite sensor according to the first embodiment. As shown in Fig. 1, the composite sensor 1 according to the first embodiment is provided with a sensor element section 10, a drive circuit 20 as a signal generation section, a first detection circuit 30, and a second detection circuit 40.

The sensor element section 10 according to the first embodiment includes an angular velocity sensor (a gyro sensor) element 100 as a first functional element, and an acceleration sensor element 200 as a second functional element. In the present embodiment, the explanation will be presented taking the case, in which both of the angular velocity sensor element 100 and the acceleration sensor element 200 are each a capacitance MEMS sensor element, as an example.

The drive circuit 20 generates a first signal (hereinafter also referred to as a drive signal) to supply the angular velocity sensor element 100. The drive circuit 20 supplies the acceleration sensor element 200 with a second signal (hereinafter also referred to as a detecting drive signal) based on the first signal. When an angular velocity is applied, the angular velocity sensor element 100 outputs a detection signal based on a variation in capacitance to the first detection circuit 30. When an acceleration is applied, the acceleration sensor element 200 outputs a detection signal based on the variation in capacitance to the second detection circuit 40.

Figs. 2A and 2B are diagrams schematically showing a sensor element section of the composite sensor according to the first embodiment. In detail, Fig. 2A is a plan view of the sensor element section, and Fig. 2B is a cross-sectional view along the line A-A' shown in Fig. 2A. It should be noted that in Figs. 2A and 2B, there are shown an X axis, a Y axis, and a Z axis as three axes perpendicular to each other, and in each of the drawings hereinafter referred to, the X axis, the Y axis, and the Z axis are also shown in a similar manner. Hereinafter, a direction (a horizontal direction) parallel to the X axis is referred to as an "X-axis direction, " a direction (a vertical direction) parallel to the Y axis is referred to as a "Y-axis direction, " and a direction parallel to the Z axis is referred to as a "Z-axis direction." Further, viewing from the Z-axis direction is referred to as a "planar view."

As shown in Figs. 2A and 2B, the sensor element section 10 is provided with a substrate 11, the angular velocity sensor element 100, the acceleration sensor element 200, and a lid body 16. It should be noted that in Fig. 2A, the graphical description of the lid body 16 is omitted. In the present embodiment, the angular velocity sensor element 100 detects the angular velocity around the Z axis, and the acceleration sensor element 200 detects the acceleration in the X-axis direction.

The material of the substrate 11 is, for example, glass or silicon. The thickness direction of the substrate 11 is the same as (parallel to) the Z-axis direction. As shown in Fig. 2A, the substrate 11 has, for example, a rectangular planar shape in the planar view. As shown in Fig. 2B, the substrate 11 has a first surface 12, and a second surface 13 on the opposite side to the first surface 12.

The first surface 12 of the substrate 11 is provided with a recessed section 14 and a recessed section 15. The recessed section 14 and the recessed section 15 each have, for example, a rectangular planar shape in the planar view. The recessed section 14 and the recessed section 15 are formed using, for example, a photolithography process and an etching process.

The angular velocity sensor element 100 and the acceleration sensor element 200 are disposed on the first surface 12 side of the substrate 11. The angular velocity sensor element 100 is disposed at a position corresponding to the recessed section 14, and the acceleration sensor element 200 is disposed at a position corresponding to the recessed section 15.

The lid body 16 is disposed on the substrate 11, and is bonded to the first surface 12 of the substrate 11. The material of the lid body 16 is, for example, glass or silicon. The method of bonding the lid body 16 and the base body 11 to each other is not particularly limited, but in the case in which, for example, the material of the substrate 11 is glass, and the material of the lid body 16 is silicon, the substrate 11 and the lid body 16 can anodically be bonded to each other.

The substrate 11 and the lid body 16 form a space 17 for housing the angular velocity sensor element 100 and the acceleration sensor element 200. The space 17 is sealed in, for example, a reduced pressure state. Thus, the vibratory phenomenon of the angular velocity sensor element 100 can be inhibited from being attenuated due to the air viscosity.

It should be noted that the acceleration sensor element 200 is not required to be sealed in the reduced pressure state, and can also be housed in an inert gas (e.g. , a nitrogen gas) atmosphere. Therefore, it is also possible to provide the lid bodies 16 separated from each other respectively to the angular velocity sensor element 100 and the acceleration sensor element 200.

Although in the example shown in Figs. 2A and 2B, the angular velocity sensor element 100 and the acceleration sensor element 200 are arranged side by side in the X-axis direction in the planar view, the direction in which the angular velocity sensor element 100 and the acceleration sensor element 200 are arranged is not particularly limited, but it is possible for the angular velocity sensor element 100 and the acceleration sensor element 200 to be arranged side by side along the Y-axis direction.

The configuration of each of the angular velocity sensor element 100 and the acceleration sensor element 200 will hereinafter be explained.

### Configuration of Angular Velocity Sensor Element

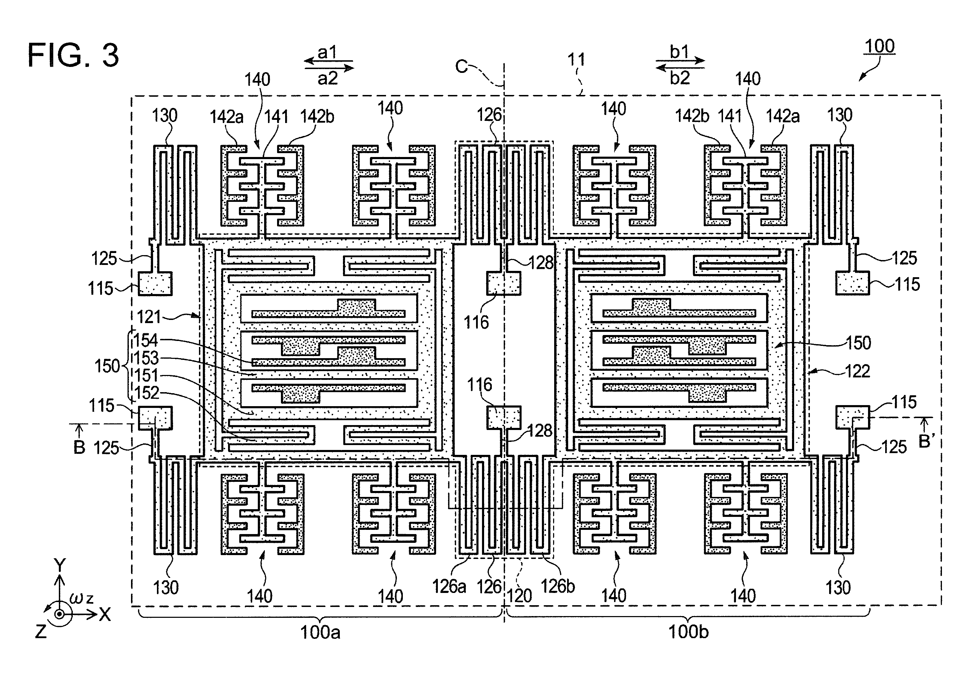

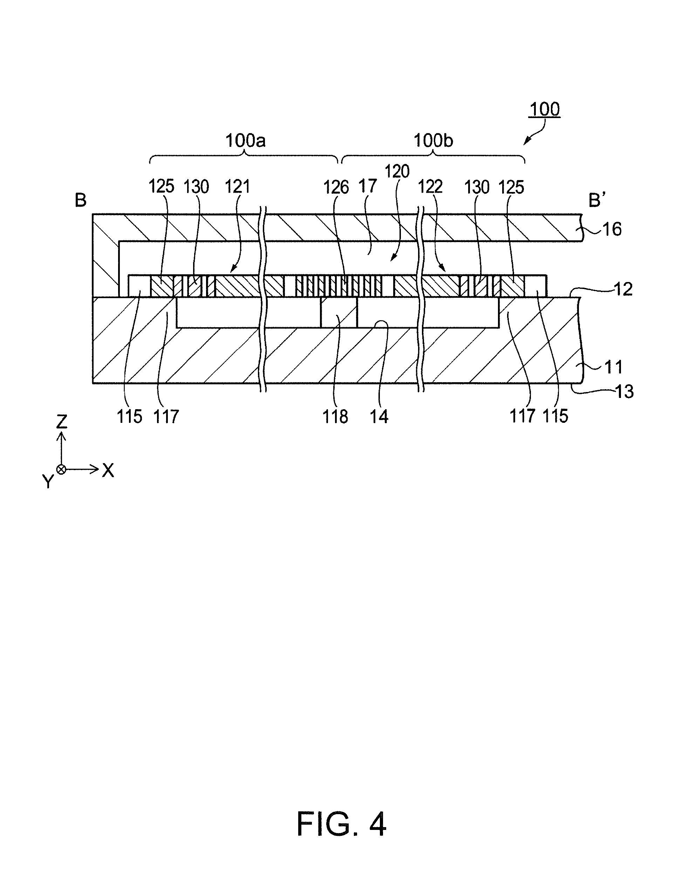

The angular velocity sensor element 100 according to the first embodiment will be explained with reference to Figs. 3 and 4. Fig. 3 is a plan view schematically showing the angular velocity sensor element according to the first embodiment. Fig. 4 is a cross-sectional view schematically showing the angular velocity sensor element according to the first embodiment. Fig. 4 corresponds to a cross-sectional view along the B-B' line shown in Fig. 3. It should be noted that in Fig. 3, the graphical description is presented seeing through the substrate 11 and the lid body 16 for the sake of convenience.

As shown in Fig. 3, the angular velocity sensor element 100 is provided with a first structure 100a and a second structure 100b. The first structure 100a and the second structure 100b are connected to each other along the X-axis direction. The first structure 100a is located on the -X direction side of the second structure 100b. The first structure 100a and the second structure 100b have, for example, a shape symmetrical about the boundary line C (a straight line along the Y-axis direction) between the first structure 100a and the second structure 100b.

The angular velocity sensor element 100 is provided with a vibrating body 120, beam sections 125, fixation sections 115, coupling sections 130, drive sections 140, and detection sections 150.

The vibrating body 120 has a first vibrating section 121, a second vibrating section 122, coupling sections 126, beam sections 128, and fixation sections 116. The first vibrating section 121 is included in the first structure 100a, and the second vibrating section 122 is included in the second structure 100b. The coupling sections 126, the beam sections 128, and the fixation sections 116 are disposed so as to straddle the boundary line C, and are shared by the first structure 100a and the second structure 100b.

The first vibrating section 121 and the second vibrating section 122 each have, for example, a roughly rectangular frame-like shape (a square shape) in the planar view. The first vibrating section 121 and the second vibrating section 122 are arranged side by side along the X-axis direction forming shapes symmetrical to each other, and are connected to each other by the coupling sections 126.

The coupling sections 126 are disposed respectively on the +Y direction side and the -Y direction side of an area disposed between the first vibrating section 121 and the second vibrating section 122. The coupling sections 126 are configured so that as the first vibrating section 121 and the second vibrating section 122 can be displaced (deformed) in the X-axis direction. More specifically, the coupling sections 126 each have a shape extending in the X-axis direction between the first vibrating section 121 and the second vibrating section 122 with a thin-width shape while reciprocating in the Y-axis direction. Thus, the first vibrating section 121 and the second vibrating section 122 can vibrate in the X-axis direction.

The two beam sections 128 and the two fixation sections 116 are disposed inside (in an area between the first vibrating section 121 and the second vibrating section 122 of) the vibrating body 120. The beam sections 128 and the fixation sections 116 are arranged so as to extend from the respective coupling sections 126 in the Y-axis direction (on the -Y direction side or the +Y direction side). It should be noted that the beam sections 128 and the fixation sections 116 can also be arranged so as to extend outward from the respective coupling sections 126.

The beam sections 128 extend from the respective coupling sections 126 inward (on the -Y direction side or the +Y direction side) along the Y-axis direction perpendicular to a direction in which the vibrating body 120 vibrates so as to form a thin-width shape, and are connected to the respective fixation sections 116. In other words, one ends of the beam sections 128 are connected to the respective coupling sections 126, and the other ends of the beam sections 128 are connected to the respective fixation sections 116. Further, the beam sections 128 are bonded and fixed to respective base body fixation sections 118 (see Fig. 4) of the substrate 11 in the respective fixation sections 116.

The configuration of the beam section 128 is not limited as long as the beam section 128 can elastically deform in the X-axis direction (the direction in which the vibrating body 120 vibrates) at a predetermined spring constant. The beam sections 128 can elastically deform in the vibration direction of the vibrating body 120, and can therefore support the coupling sections 126 without hindering the mutual vibration energy exchange between the first vibrating section 121 and the second vibrating section 122.

The material of the vibrating body 120 is silicon provided with electrical conductivity by doping impurities such as phosphorus or boron. The vibrating body 120 is formed by, for example, processing a silicon substrate (not shown) using a photolithography process and an etching process.

The two coupling sections 130, the two beam sections 125, and the two fixation sections 115 are disposed to each of the first structure 100a and the second structure 100b, and are disposed on the both ends in the X-axis direction of the vibrating body 120 (the first vibrating section 121 and the second vibrating section 122).

The two coupling sections 130 are disposed to each of the first vibrating section 121 and the second vibrating section 122 so as to be opposed to the coupling sections 126 at the center of the vibrating body 120. The coupling sections 130 are each configured so that the vibrating body 120 can be displaced in the X-axis direction.

Specifically, one ends of the coupling sections 130 are connected to the fixation sections 115 via the beam sections 125, respectively, and the other ends of the coupling sections 130 are connected to the vibrating body 120 (the first vibrating section 121 and the second vibrating section 122). Further, the coupling sections 130 each have a thin-width shape extending from the coupling section with the corresponding beam section 125 to the vibrating body 120 (the first vibrating section 121 and the second vibrating section 122) in the X-axis direction while reciprocating in the Y-axis direction.

The two beam sections 125 are disposed to each of the first vibrating section 121 and the second vibrating section 122 so as to be opposed to the beam sections 128 at the center of the vibrating body 120. The beam sections 125 extend from the respective coupling sections 130 toward the -Y direction or the +Y direction along the Y-axis direction perpendicular to a direction in which the vibrating body 120 vibrates so as to form a thin-width shape, and are connected to the respective fixation sections 115.

In other words, one ends of the beam sections 125 are connected to the respective coupling sections 130, and the other ends of the beam sections 125 are connected to the respective fixation sections 115. Further, the beam sections 125 are bonded and fixed to respective base body fixation sections 117 (see Fig. 4) of the substrate 11 in the respective fixation sections 115. The configuration of the beam section 125 is not limited as long as the beam section 125 can elastically deform in the X-axis direction (the direction in which the vibrating body 120 vibrates) at a predetermined spring constant.

The two fixation sections 115 are disposed to each of the first vibrating section 121 and the second vibrating section 122 so as to be opposed to the fixation sections 116 at the center of the vibrating body 120. Thus, the vibrating body 120 is supported by the base body fixation section 117 with the fixation sections 116 via the beam sections 128 connected to the coupling sections 126, respectively, and the fixation sections 115 via the beam sections 125 connected to the coupling sections 130, respectively, and is disposed separately from the substrate 11.

The beam sections 128 and the fixation sections 116, and the beam section 125 and the fixation sections 115 are arranged so as to extend in the same direction along the Y-axis direction. By the beam sections 128 and the fixation sections 116, and the beam sections 125 and the fixation sections 115 being arranged in this manner, the support balance of the vibrating body 120 is improved, and the support of the vibrating body 120 (the first vibrating section 121 and the second vibrating section 122) is stabilized. Thus, it becomes possible to reduce the tilt of the vibrating body 120.

The material of the coupling sections 130, the beam sections 125, and the fixation sections 115 is silicon provided with electrical conductivity by doping impurities such as phosphorus or boron. The coupling sections 130, the beam sections 125, and the fixation sections 115 are formed by, for example, processing a silicon substrate (not shown) integrally with the vibrating body 120 using a photolithography process and an etching process.

The four drive sections 140 are disposed to each of the first structure 100a and the second structure 100b, and are disposed on the both ends in the Y-axis direction of the vibrating body 120 (the first vibrating section 121 and the second vibrating section 122). The drive sections 140 each have a mechanism for exciting the vibration of the vibrating body 120 (the first vibrating section 121 and the second vibrating section 122). The configuration and the number of the drive sections 140 are not particularly limited as long as the drive sections 140 can excite the vibration of the first vibrating section 121 and the second vibrating section 122.

In the present embodiment, the drive sections 140 each have a driving movable electrode section 141 connected on the outer side of the vibrating body 120, and driving stationary electrodes 142a, 142b disposed so as to be opposed to each other with predetermined distances from the driving movable electrode section 141. The driving movable electrode section 141 and the driving stationary electrode sections 142a, 142b are electrically connected to the drive circuit 20 (see Fig. 1) via wiring section (not shown).

Two or more driving movable electrode sections 141 can be disposed so as to be connected to the first vibrating section 121 and the second vibrating section 122. In the example shown in Fig. 3, the driving movable electrode section 141 is disposed so as to have a comb-like shape having a trunk section extending in the +Y direction (or the -Y direction) from the first vibrating section 121 or the second vibrating section 122, and a plurality of branch sections extending in the +X direction and the -X direction from the trunk section.

The driving stationary electrode sections 142a, 142b are disposed on the outer side in the X-axis direction of the driving movable electrode section 141. More specifically, in the first vibrating section 121, the driving stationary electrode section 142a is disposed on the -X direction side of the driving movable electrode section 141, and the driving stationary electrode section 142b is disposed on the +X direction side of the driving movable electrode section 141. In contrast, in the second vibrating section 122, the driving stationary electrode section 142a is disposed on the +X direction side of the driving movable electrode section 141, and the driving stationary electrode section 142b is disposed on the -X direction side of the driving movable electrode section 141.

The driving stationary electrode sections 142a, 142b are bonded and fixed to the first surface 12 (see Fig. 4) of the substrate 11. In the example shown in Fig. 3, two or more driving stationary electrode sections 142a, 142b are disposed, and are disposed so as to be opposed to each other across the driving movable electrode section 141 from each other. In the case in which the driving movable electrode section 141 has the comb-like shape, the driving stationary electrode sections 142a, 142b can each be a comb-like electrode having a shape corresponding to the shape of the driving movable electrode section 141.

The material of the drive sections 140 is silicon provided with electrical conductivity by doping impurities such as phosphorus or boron. The drive sections 140 are formed by, for example, processing a silicon substrate (not shown) integrally with the vibrating body 120 using a photolithography process and an etching process.

The detection sections are respectively disposed to the first structure 100a and the second structure 100b. In the example shown in Fig. 3, the detection sections 150 are disposed inside the first vibrating section 121 and the second vibrating section 122, respectively. The detection sections 150 are each provided with a detecting support section 151, detecting spring sections 152, detecting movable electrodes 153, and detecting stationary electrodes 154. The detecting support section 151 has, for example, a frame-like shape. The shape of the detecting support section 151 is not particularly limited as long as it is a loop shape.

The detecting spring sections 152 are disposed outside the detecting support section 151. The detecting spring sections 152 connect the detecting support section 151 to the first vibrating section 121 or the second vibrating section 122 of the vibrating body 120. More specifically, one ends of the detecting spring sections 152 are connected to the detecting support section 151. The other ends of the detecting spring sections 152 are connected to the first vibrating section 121 or the second vibrating section 122 of the vibrating body 120. The detecting spring sections 152 are configured so that the detecting support section 151 can be displaced in the Y-axis direction. More specifically, the detecting spring sections 152 each have a shape extending in the Y-axis direction while reciprocating in the X-axis direction.

The detecting movable electrode sections 153 are disposed inside the detecting support section 151 so as to be connected to the detecting support section 151. In the example shown in Fig. 3, the detecting movable electrode sections 153 extend in the X-axis direction. The detecting stationary electrode sections 154 are disposed inside the detecting support section 151. The detecting stationary electrodes 154 are bonded and fixed to the fist surface 12 of the substrate 11. In the example shown in Fig. 3, two or more detecting stationary electrode sections 154 are provided, and are disposed so as to be opposed to each other across each of the detecting movable electrode sections 153 from each other.

The detecting movable electrode sections 153 and the detecting stationary electrode sections 154 are electrodes for detecting a signal (capacitance) varying in accordance with the vibration of the vibrating body 120. The angular velocity sensor element 100 is capable of detecting the angular velocity around the Z axis by detecting the variation in the capacitance between the detecting movable electrode sections 153 and the respective detecting stationary electrode sections 154.

The material of the detection sections 150 is silicon provided with electrical conductivity by doping impurities such as phosphorus or boron. The detection sections 150 are formed by, for example, processing a silicon substrate (not shown) integrally with the vibrating body 120 using a photolithography process and an etching process. It should be noted that the detection sections 150 can also be disposed outside the first vibrating section 121 and the second vibrating section 122, respectively.

As shown in Fig. 4, the vibrating body 120 is housed in the space 17 formed by the substrate 11 and the lid body 16. The vibrating body 120 is disposed above the substrate 11 via a gap (a recessed section 14). Due to the gap (the recessed section 14), the vibrating body 120 can move in a desired direction without being hindered by the substrate 11.

The substrate 11 has the base body fixation sections 117 and the base body fixation sections 118 appropriately disposed on the first surface 12 in accordance with the configuration of the vibrating body 120. The base body fixation sections 117 are connected to the fixation sections 115 via the coupling sections 130, and the beam sections 125 respectively extending from the coupling sections 130 in the Y-axis direction, and support the vibrating body 120. The base body fixation sections 118 are connected to the fixation sections 116 (see Fig. 3) via the coupling sections 126 for coupling the first vibrating section 121 and the second vibrating section 122 to each other, and the beam sections 128 (see Fig. 3), and thus support the vibrating body 120.

The fixation (bonding) method of the first surface 12 (the substrate 11) of the base body fixation sections 117 and the base body fixation sections 118 to the coupling sections 130 (the fixation sections 115), the coupling sections 126 (the fixation sections 116) shown in Fig. 4, the driving stationary electrode sections 142, the detecting stationary electrode sections 154, and so on shown in Fig. 3 is not particularly limited. In the case in which, for example, the material of the substrate 11 is glass, the material of the vibrating body 120 and so on is silicon, anodic bonding can be applied as the fixation (bonding) method.

### Action of Angular Velocity Sensor Element

The action of the angular velocity sensor element 100 according to the first embodiment will be explained. In the angular velocity sensor element 100 shown in Fig. 3, the driving movable electrode sections 141 and the driving stationary electrode sections 142a, 142b of the respective drive sections 140 are electrically connected to the drive circuit 20 (see Fig. 1). A drive signal as a first signal is applied from the drive circuit 20 to the driving movable electrode sections 141 and the driving stationary electrode sections 142a, 142b.

When the drive signal is applied to the driving movable electrode sections 141 and the driving stationary electrode sections 142a, 142b, an electrostatic force occurs between the driving movable electrode sections 141 and the driving stationary electrode sections 142a, 142b. Thus, the coupling sections 130 expand and contract in the X-axis direction, and the vibrating body 120 (the first vibrating section 121 and the second vibrating section 122) vibrates in the X-axis direction.

More specifically, the drive circuit 20 provides the driving movable electrode sections 141 with a predetermined electrical potential Vr, and applies a direct-current voltage to the driving stationary electrode sections 142a based on an electrical potential Vr1. Further, the drive circuit 20 applies an alternating-current voltage to the driving stationary electrode sections 142b based on an electrical potential Vr2. The alternating-current voltage is, for example, a rectangular wave with a predetermined frequency of about several tens of kilohertz.

Here, in the driving stationary electrode sections 142a, 142b across the driving movable electrode section 141 from each other, the driving stationary electrode section 142a is disposed on the -X direction side of the driving movable electrode section 141, and the driving stationary electrode section 142b is disposed on the +X direction side of the driving movable electrode section 141 in the first structure 100a. In the second structure 100b, the driving stationary electrode section 142a is disposed on the +X direction side of the driving movable electrode section 141, and the driving stationary electrode section 142b is disposed on the -X direction side of the driving movable electrode section 141.

Therefore, as in the example shown in Fig. 3, when the first vibrating section 121 is displaced in the a1 direction, the second vibrating section 122 is displaced in the b1 direction opposite to the a1 direction, and when the first vibrating section 121 is displaced in the a2 direction, the second vibrating section 122 is displaced in the b2 direction opposite to the a2 direction. Therefore, due to the direct-current voltage based on the electrical potential Vr1 and the alternating-current voltage based on the electrical potential vr2, it is possible to vibrate (make a tuning-fork vibration of) the first vibrating section 121 of the first structure 100a and the second vibrating section 122 of the second structure 100b on the respective phases opposite to each other at a predetermined frequency in the X-axis direction.

It should be noted that the part of each of the detection sections 150 connected to the vibrating body 120 (the first vibrating section 121 or the second vibrating section 122) is displaced in the X-axis direction in accordance with the vibration of the vibrating body 120 (the first vibrating section 121 or the second vibrating section 122).

When an angular velocity ωz around the Z axis is applied to the angular velocity sensor element 100 in the state in which the first vibrating section 121 and the second vibrating section 122 vibrate in the X-axis direction, a Coriolis force acts on each of the detection sections 150 and the detection sections 150 are displaced in the Y-axis direction. More specifically, the detection section 150 coupled to the first vibrating section 121 of the first structure 100a and the detection section 150 coupled to the second vibrating section 122 of the second structure 100b are displaced along the Y-axis direction in the respective directions opposite to each other.

By the detection sections 150 being displaced in the Y-axis direction, the distances between the detecting movable electrode sections 153 and the respective detecting stationary electrode sections 154 are varied. Therefore, the capacitance between the detecting movable electrode sections 153 and the detecting stationary electrode sections 154 varies. The variation in the capacitance detected by the detection sections 150 is output to the first detection circuit 30 (see Fig. 1) as the detection signal. The angular velocity sensor element 100 is capable of detecting the angular velocity ωz around the Z axis based on the variation in the capacitance detected by the detection sections 150.

In the angular velocity sensor element 100, as described above, the detection section 150 of the first structure 100a and the detection section 150 of the second structure 100b are displaced in the respective directions opposite to each other. Therefore, in the angular velocity sensor element 100, for example, the error caused by the acceleration in the Y-axis direction can be canceled out using the signal processing, and thus the detection accuracy of the angular velocity ωz around the Z axis can be improved.

It should be noted that although not shown in the drawing, it is also possible to adopt a configuration of providing the angular velocity sensor element 100 with a monitor electrode section having the same configuration as the drive section 140 (the driving movable electrode section 141 and the driving stationary electrode sections 142a, 142b). By adopting such a configuration, by the vibrating body 120 (the first vibrating section 121 and the second vibrating section 122) vibrating in the X-axis direction, the capacitance between the movable electrode section and the stationary electrode section in the monitor electrode section is varied. By feeding back the variation in the capacitance to the drive circuit 20 as a current signal, it is possible to monitor the vibrating state (e.g., the vibration amplitude) of the vibrating body 120 to thereby perform the feedback control on the drive signal to be applied to the drive sections 140.

Further, although in the above explanation, it is assumed that the first signal (the drive signal) is the rectangular wave, the first signal can also be a sinusoidal wave. The rectangular wave is configured by adding a basic sinusoidal wave and sinusoidal waves with frequencies, which are plural multiples of the frequency of the basic sinusoidal wave, to each other. Therefore, if the rectangular wave is used as the first signal, harmonic components (noise to the drive signal) are mixed to the first signal in some cases. In such a case, by using the sinusoidal wave as the first signal, the noise in the first signal and the second signal due to the harmonic components can be reduced.

### Configuration of Acceleration Sensor Element

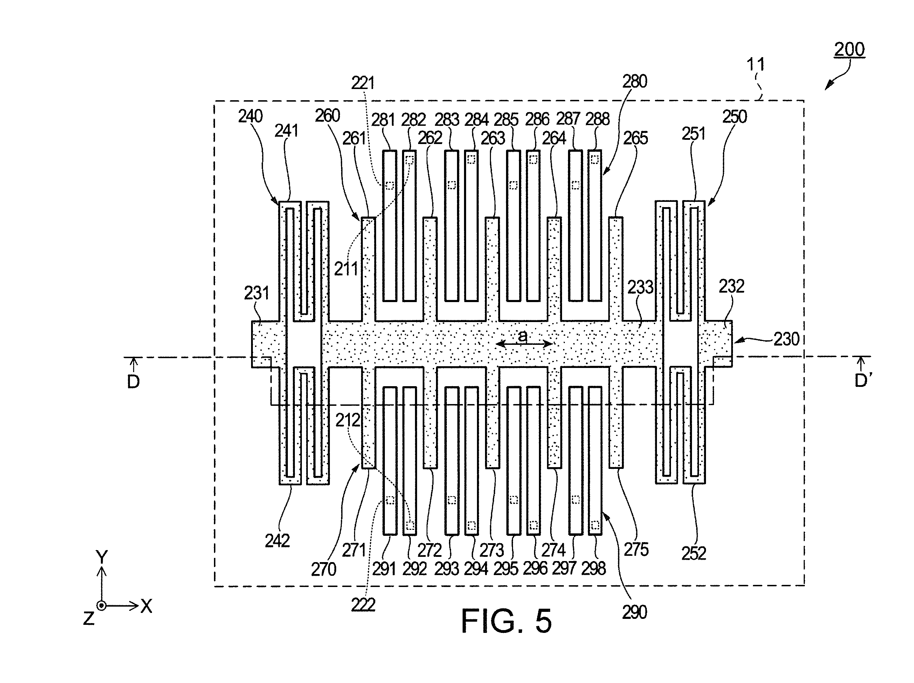

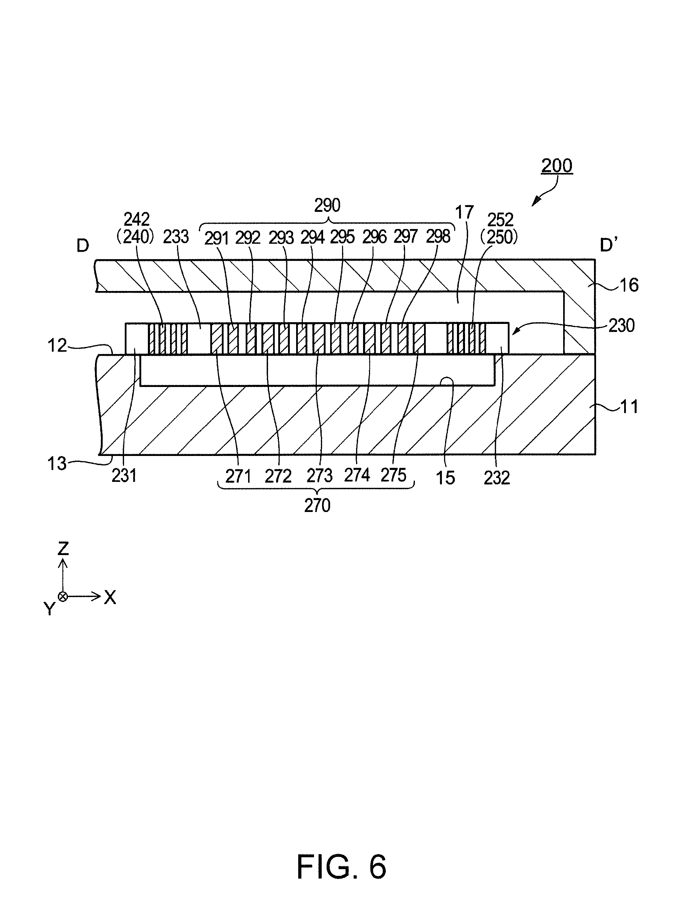

Subsequently, the acceleration sensor element 200 according to the first embodiment will be explained with reference to Figs. 5 and 6. Fig. 5 is a plan view schematically showing the acceleration sensor element according to the first embodiment. Fig. 6 is a cross-sectional view schematically showing the acceleration sensor element according to the first embodiment. Fig. 6 corresponds to a cross-sectional view along the D-D' line shown in Fig. 5. It should be noted that in Fig. 5, the graphical description is presented seeing through the substrate 11 and the lid body 16 for the sake of convenience.

As shown in Fig. 5, the acceleration sensor element 200 is provided with a vibrating body 230, a stationary electrode section 280, and a stationary electrode section 290. The vibrating body 230 is provided with fixation sections 231, 232, a movable section 233, coupling sections 240, 250, and movable electrode sections 260, 270. In the present embodiment, the acceleration sensor element 200 detects the acceleration in the X-axis direction.

The fixation sections 231, 232 of the movable body 230, the movable section 233, the coupling sections 240, 250, and the movable electrode sections 260, 270 are formed integrally. The fixation sections 231, 232 are each bonded to the first surface 12 (see Fig. 6) of the substrate 11.

Specifically, as shown in Fig. 6, the fixation section 231 is bonded to the first surface 12 of the substrate 11 on the -X direction side (on the left side in the drawing) with respect to the recessed section 15. The fixation section 232 is bonded to the first surface 12 of the substrate 11 on the +X direction side (on the right side in the drawing) with respect to the recessed section 15. Further, the fixation sections 231, 232 are each disposed so as to straddle the outer circumferential edge of the recessed section 15 in the planar view. It should be noted that the positions, the shapes, and so on of the fixation sections 231, 232 are determined in accordance with the positions, the shapes, and so on of the coupling sections 240, 250, a wiring section (not shown), and so on, and are not limited to those described above.

Between the fixation sections 231, 232, there is disposed the movable section 233. The movable section 233 has, for example, an elongated shape extending in the X-axis direction. It should be noted that the shape of the movable section 233 is determined in accordance with the shapes, the sizes, and so on of the parts constituting the vibrating body 230, and is not limited to that described above.

The movable section 233 is coupled to the fixation sections 231, 232 via the coupling sections 240, 250. In the example shown in Fig. 5, an end portion on the -X direction side of the movable section 233 is coupled to the fixation section 231 via the coupling section 240, and an end portion on the +X direction side of the movable section 233 is coupled to the fixation section 232 via the coupling section 250. The coupling sections 240, 250 connect the movable section 233 to the fixation sections 231, 232 so as to be able to be displaced with respect to the fixation sections 231, 232, respectively.

As shown in Fig. 5, the coupling section 240 is formed of two beams 241, 242. The beams 241, 242 each form a shape extending in the X-axis direction while meandering in the Y-axis direction. In other words, the beams 241, 242 each have a shape folded a plurality of times (three times in the example shown in Fig. 5) in the Y-axis direction. It should be noted that the number of times of the folding of each of the beams 241, 242 can be one or two, or can be four or more.

Similarly, the coupling section 250 is formed of two beams 251, 252 each having a shape extending in the X-axis direction while meandering in the Y-axis direction. It should be noted that the coupling sections 240, 250 are not limited to those described above providing the movable section 233 is supported so as to be displaced with respect to the substrate 11. For example, the coupling sections 240, 250 can be formed of a pair of beams respectively extending from the both end portions of the movable section 233 in the +Y direction and the -Y direction.

Thus, the movable section 233 is configured so as to be able to be displaced in the X-axis direction (the +X direction or the -X direction) with respect to the substrate 11 as indicated by the arrow a while elastically deforming the coupling sections 240, 250. It should be noted that the resonant frequency of the movable section 233 is, for example, about several kilohertz.

The movable electrode section 260 is disposed on one side (the +Y direction side) in the width direction (the Y-axis direction) of the movable section 233, which is supported so as to be able to be displaced in the X-axis direction, and the movable electrode section 270 is disposed on the other side (the -Y direction side). The movable electrode section 260 is disposed so as to be opposed to the stationary electrode section 280 with gaps. Further, the movable electrode section 270 is disposed so as to be opposed to the stationary electrode section 290 with gaps.

The movable electrode section 260 is provided with a plurality of movable electrode fingers 261, 262, 263, 264, and 265 projecting from the movable section 233 in the +Y direction, and arranged to form a comb-like shape. Similarly, the movable electrode section 270 is provided with a plurality of movable electrode fingers 271, 272, 273, 274, and 275 projecting from the movable section 233 in the -Y direction, and arranged to form a comb-like shape. The movable electrode fingers 261 through 265 and the movable electrode fingers 271 through 275 are each arranged side by side in a direction from the -X direction side toward the +X direction side in this order. The movable electrode fingers 261 through 265 and the movable electrode fingers 271 through 275 are each disposed so as to be arranged side by side in a direction (i.e., the X-axis direction) along which the movable section 233 is displaced.

The stationary electrode section 280 is provided with a plurality of stationary electrode fingers 281, 282, 283, 284, 285, 286, 287, and 288 arranged so as to form a comb-like shape interdigitating with the plurality of movable electrode fingers 261 through 265 of the movable electrode section 260 with gaps. The end portions of the plurality of stationary electrode fingers 281 through 288 disposed on the opposite side to the movable section 233 are each bonded to the first surface 12 of the substrate 11 on the +Y direction side with respect to the recessed section 15 (see Fig. 6). Further, in each of the stationary electrode fingers 281 through 288, the end located on the bonded side acts as a fixed end, and a free end extends toward the -Y direction.

The stationary electrode fingers 281 through 288 are arranged side by side in a direction from the -X direction side toward the +X direction side in this order. Further, the stationary electrode fingers 281, 282 form a pair, and are disposed between the movable electrode fingers 261, 262 so as to face the movable electrode fingers 261, 262, respectively. The stationary electrode fingers 283, 284 form a pair, and are disposed between the movable electrode fingers 262, 263 so as to face the movable electrode fingers 262, 263, respectively. The stationary electrode fingers 285, 286 form a pair, and are disposed between the movable electrode fingers 263, 264 so as to face the movable electrode fingers 263, 264, respectively. The stationary electrode fingers 287, 288 form a pair, and are disposed between the movable electrode fingers 264, 265 so as to face the movable electrode fingers 264, 265, respectively.

The stationary electrode fingers 282, 284, 286, and 288 respectively correspond to first stationary electrode fingers, and the stationary electrode fingers 281, 283, 285, and 287 respectively correspond to second stationary electrode fingers separated from the first stationary electrode fingers on the substrate 11 with air gaps (gaps). As described above, the plurality of stationary electrode fingers 281 through 288 is constituted by the plurality of first stationary electrode fingers and the plurality of second stationary electrode fingers arranged alternately.

In other words, with respect to the movable electrode fingers 261, 262, 263, 264, and 265 of the movable electrode section 260, the first stationary electrode fingers 282, 284, 286, and 288 are arranged on one side (the -X direction side), and the second stationary electrode fingers 281, 283, 285, and 287 are arranged on the other side (the +X direction side).

The stationary electrode fingers 281 through 288 are separated from each other on the substrate 11. In other words, the stationary electrode fingers 281 through 288 are not connected to each other on the substrate 11, and are isolated like islands. Thus, it is possible to uniform the lengths of the stationary electrode fingers 281 through 288 in the Y-axis direction. Therefore, it is possible to achieve miniaturization of the stationary electrode fingers 281 through 288 while keeping the area necessary to obtain sufficient bonding strength of the bonding section between each of the stationary electrode fingers 281 through 288 and the substrate 11.

Further, the first stationary electrode fingers (the stationary electrode fingers 282, 284, 286, and 288) and the second stationary electrode fingers (the stationary electrode fingers 281, 283, 285, and 287) are separated from each other on the substrate 11. Thus, the first stationary electrode fingers and the second electrode fingers can electrically be insulated from each other.

Similarly, the stationary electrode section 290 is provided with a plurality of stationary electrode fingers 291, 292, 293, 294, 295, 296, 297, and 298 arranged so as to form a comb-like shape interdigitating with the plurality of movable electrode fingers 271 through 275 of the movable electrode section 270 with gaps. The end portions of the plurality of stationary electrode fingers 291 through 298 disposed on the opposite side to the movable section 233 are each bonded to a part of the first surface 12 of the substrate 11 on the -Y direction side with respect to the recessed section 15 (see Fig. 6). Further, in each of the stationary electrode fingers 291 through 298, the end located on the bonded side acts as a fixed end, and a free end extends toward the +Y direction.

The stationary electrode fingers 291 through 298 are arranged side by side in a direction from the -X direction side toward the +X direction side in this order. Further, the stationary electrode fingers 291, 292 form a pair and are disposed so as to face between the movable electrode fingers 271, 272, the stationary electrode fingers 293, 294 form a pair and are disposed so as to face between the movable electrode fingers 272, 273, the stationary electrode fingers 295, 296 form a pair and are disposed so as to face between the movable electrode fingers 273, 274, and the stationary electrode fingers 297, 298 form a pair and are disposed so as to face between the movable electrode fingers 274, 275.

The stationary electrode fingers 292, 294, 296, and 298 respectively correspond to the first stationary electrode fingers, and the stationary electrode fingers 291, 293, 295, and 297 respectively correspond to the second stationary electrode fingers separated from the first stationary electrode fingers on the substrate 11 with air gaps (gaps). As described above, the plurality of stationary electrode fingers 291 through 298 is constituted by the plurality of first stationary electrode fingers and the plurality of second stationary electrode fingers arranged alternately.

In other words, with respect to the movable electrode fingers 271, 272, 273, 274, and 275 of the movable electrode section 270, the first stationary electrode fingers 292, 294, 296, and 298 are arranged on one side (the -X direction side), and the second stationary electrode fingers 291, 293, 295, and 297 are arranged on the other side (the +X direction side).

Also in the stationary electrode section 290, the first stationary electrode fingers (the stationary electrode fingers 292, 294, 296, and 298) and the second stationary electrode fingers (the stationary electrode fingers 291, 293, 295, and 297) are separated from each other on the substrate 11 similarly to the stationary electrode section 280. Further, also in the stationary electrode section 290, the plurality of stationary electrode fingers 291 through 298 is separated from each other on the substrate 11 similarly to the stationary electrode section 280. Thus, it is possible to achieve miniaturization of the stationary electrode fingers 291 through 298 while making the area of the bonding section between each of the stationary electrode fingers 291 through 298 and the substrate 11 sufficient.

The first stationary electrode fingers 282, 284, 286, and 288 of the stationary electrode section 280 are electrically connected to a wiring section (not shown) via respective connection sections 211, and the first stationary electrode fingers 292, 294, 296, and 298 of the stationary electrode section 290 are also electrically connected to the same wiring section as the wiring section, to which the first stationary electrode fingers of the stationary electrode section 280 are connected, via respective connection sections 212. Further, the second stationary electrode fingers 281, 283, 285, and 287 of the stationary electrode section 280 are electrically connected to a wiring section (not shown) different from the wiring section, to which the first stationary electrode fingers described above are connected, via respective connection sections 221, and the second stationary electrode fingers 291, 293, 295, and 297 of the stationary electrode section 290 are also electrically connected to the same wiring section as the wiring section, to which the second stationary electrode fingers of the stationary electrode section 290 are connected, via respective connection sections 222.

When the dimensions of the gaps between the movable electrode fingers 261 through 265 of the movable electrode section 260, and the first stationary electrode fingers 282, 284, 286, and 288 and the second stationary electrode fingers 281, 283, 285, and 287 of the stationary electrode section 280 are varied, the amount of the capacitance between the movable electrode section 260 and the stationary electrode section 280 varies. Since the first stationary electrode fingers and the second stationary electrode fingers of the stationary electrode section 280 are electrically connected to the respective wiring sections different from each other, the capacitance between the first stationary electrode fingers of the stationary electrode section 280 and the movable electrode section 260 and the capacitance between the second stationary electrode fingers of the stationary electrode section 280 and the movable electrode section 260 can separately be measured.

Similarly, when the dimensions of the gaps between the movable electrode fingers 271 through 275 of the movable electrode section 270, and the first stationary electrode fingers 292, 294, 296, and 298 and the second stationary electrode fingers 291, 293, 295, and 297 of the stationary electrode section 290 are varied, the amount of the capacitance between the movable electrode section 270 and the stationary electrode section 290 varies. Since the first stationary electrode fingers and the second stationary electrode fingers of the stationary electrode section 290 are electrically connected to the respective wiring sections different from each other, the capacitance between the first stationary electrode fingers of the stationary electrode section 290 and the movable electrode section 270 and the capacitance between the second stationary electrode fingers of the stationary electrode section 290 and the movable electrode section 270 can separately be measured.

As described above, the acceleration sensor element 200 is capable of detecting the acceleration in the X-axis direction by detecting the variation in the capacitance between the movable electrode sections 260, 270 and the respective stationary electrode sections 280, 290.

The vibrating body 230 (the fixation sections 231, 232, the movable section 233, the coupling sections 240, 250, the movable electrode sections 260, 270, and the stationary electrode sections 280, 290) is formed by etching a single substrate (not shown). Thus, the thickness of each of the sections of the vibrating body 230 can be increased, and it is possible to easily and accurately uniform the thickness of these sections. As a result, increase in sensitivity of the acceleration sensor element 200 can be achieved, and at the same time, impact resistance of the acceleration sensor element 200 can also be improved.

The constituent material of the vibrating body 230 is not particularly limited providing the physical quantity can be detected based on the variations in the capacitances described above, but semiconductor is preferable, and specifically, a silicon material such as single-crystal silicon or polysilicon is preferably used.

As shown in Fig. 6, the vibrating body 230 is housed in the space 17 formed by the substrate 11 and the lid body 16. The vibrating body 230 is disposed above the substrate 11 via a gap (the recessed section 15). Due to the gap (the recessed section 15), the vibrating body 230 can move in a desired direction without being hindered by the substrate 11.

Further, the vibrating body 230 is supported by the substrate 11 due to the fixation sections 231, 232, the stationary electrode section 280 (see Fig. 5), and the stationary electrode section 290 bonded to the first surface 12 of the substrate 11. The bonding method between the vibrating body 230 (the fixation sections 231, 232 and the stationary electrode sections 280, 290) and the substrate 11 is not particularly limited, but the anodic bonding process is preferably used.

According to the anodic bonding process, since the fixation sections 231, 232 and the stationary electrode sections 280, 290 can solidly be bonded to the substrate 11, the impact resistance of the acceleration sensor element 200 can be improved. Further, since the fixation sections 231, 232 and the stationary electrode sections 280, 290 can accurately be bonded to desired positions of the substrate 11, increase in sensitivity of the acceleration sensor element 200 can be achieved.

### Action of Acceleration Sensor Element

The action of the acceleration sensor element 200 according to the first embodiment will be explained. In the acceleration sensor element 200 shown in Fig. 5, a detecting drive signal as the second signal is applied to the vibrating body 230 from the drive circuit 20 (see Fig. 1). More specifically, a predetermined electrical potential and an alternating-current voltage with a predetermined frequency based on the electrical potential are applied to the vibrating body 230. The alternating-current voltage is, for example, a rectangular wave with a predetermined frequency of about several tens of kilohertz. In the present embodiment, as the detecting drive signal (the second signal) of the acceleration sensor element 200, a signal (the first signal) similar to the drive signal of the angular velocity sensor element 100 is supplied from the drive circuit 20.

Further, the variation of the capacitance between the movable electrode section 260 of the vibrating body 230 and the first stationary electrode fingers 282, 284, 286, and 288 of the stationary electrode section 280, and between the movable electrode section 270 of the vibrating body 230 and the first stationary electrode fingers 292, 294, 296, and 298 of the stationary electrode section 290 is output to the second detection circuit 40 (see Fig. 1) as the detection signal.

Similarly, the variation of the capacitance between the movable electrode section 260 and the second stationary electrode fingers 281, 283, 285, and 287 of the stationary electrode section 280, and between the movable electrode section 270 and the second stationary electrode fingers 291, 293, 295, and 297 of the stationary electrode section 290 is also output to the second detection circuit 40 as the detection signal.

The frequency (about several tens kilohertz) of the detecting drive signal to be applied to the vibrating body 230 is dramatically higher than the resonant frequency (on the order of several kilohertz) of the vibrating body 230 (the movable section 233). Therefore, the resonance of the vibrating body 230 (the movable section 233) is suppressed, and in the state in which no acceleration in the X-axis direction is applied to the acceleration sensor element 200, the vibrating body 230 (the movable section 233) becomes in a roughly resting state. Therefore, the capacitance between the movable electrode sections 260, 270 of the vibrating body 230 and the stationary electrode sections 280, 290 hardly varies.

When the acceleration in the X-axis direction is applied to the acceleration sensor element 200, the vibrating body 230 (the movable section 233) is displaced in the X-axis direction in accordance with the acceleration applied. Therefore, the movable electrode sections 260, 270 are displaced in the X-axis direction. Therefore, the capacitance between the movable electrode section 260 and the first stationary electrode fingers of the stationary electrode section 280, and the capacitance between the movable electrode section 260 and the second stationary electrode fingers of the stationary electrode section 280 vary. Similarly, the capacitance between the movable electrode section 270 and the first stationary electrode fingers of the stationary electrode section 290, and the capacitance between the movable electrode section 270 and the second stationary electrode fingers of the stationary electrode section 290 also vary. In the acceleration sensor element 200, the acceleration in the X-axis direction can be detected based on the variations of these capacitances.

In the case in which, for example, the acceleration in the +X direction is applied to the acceleration sensor element 200, the movable electrode sections 260, 270 are displaced in the +X direction. Therefore, the capacitance between the movable electrode fingers 261, 262, 263, 264, and 265 and the first stationary electrode fingers 282, 284, 286, and 288 located on the -X direction side of the movable electrode fingers decreases. Similarly, the capacitance between the movable electrode fingers 271, 272, 273, 274, and 275 and the first stationary electrode fingers 292, 294, 296, and 298 located on the -X direction side of the movable electrode fingers also decreases.

In contrast, the capacitance between the movable electrode fingers 261, 262, 263, 264, and 265 and the second stationary electrode fingers 281, 283, 285, and 287 located on the +X direction side of the movable electrode fingers increases. Similarly, the capacitance between the movable electrode fingers 271, 272, 273, 274, and 275 and the second stationary electrode fingers 291, 293, 295, and 297 located on the +X direction side of the movable electrode fingers also increases.

In the acceleration sensor element 200, the variation of the capacitance between the movable electrode sections 260, 270 and the first stationary electrode fingers of the stationary electrode sections 280, 290 and the variation of the capacitance between the movable electrode sections 260, 270 and the second stationary electrode fingers of the stationary electrode sections 280, 290 are measured separately from each other, and then the acceleration in the X-axis direction is detected based on these measurement results.

The movable electrode fingers of the movable electrode sections 260, 270 and the first stationary electrode fingers and the second stationary electrode fingers of the stationary electrode sections 280, 290 are each arranged side by side in the direction (i.e. , the X-axis direction) in which the movable section 233 is displaced. Thus, it is possible to efficiently vary the capacitance between the movable electrode sections 260, 270 and the stationary electrode sections 280, 290 in accordance with the displacement of the movable section 233. Therefore, in the acceleration sensor element 200, the detection accuracy of the acceleration in the X-axis direction can be made excellent.

As explained hereinabove, the composite sensor 1 according to the present embodiment is a composite device having the angular velocity sensor element 100 and the acceleration sensor element 200 in the sensor element section 10. Further, in the composite sensor 1, there is adopted a configuration in which the drive circuit 20 supplies the angular velocity sensor element 100 with the drive signal, and at the same time supplies the acceleration sensor element 200 with the detecting drive signal for detecting the capacitance variation.

Here, the circuit configuration of the composite sensor 1 according to the present embodiment and the circuit configuration of the composite sensor of the related art are compared with each other. Fig. 18 is a block diagram showing an example of a schematic configuration of the composite sensor of the related art. The composite sensor 6 shown in Fig. 18 has a first functional element (an angular velocity sensor element) 100 and a second functional element (an acceleration sensor element) 200 in a sensor element section 10 similarly to the composite sensor described in Document 1.

As shown in Fig. 18, the composite sensor 6 has a first drive circuit 20 for supplying the angular velocity sensor element 100 with the first signal (the drive signal), and a second drive circuit 70 for supplying the acceleration sensor element 200 with the second signal (the detecting drive signal). In other words, the composite sensor 6 has two drive circuits as a signal generation section. Therefore, in the composite sensor 6, there is required a space for disposing the two drive circuits, and at the same time, current is consumed in each of the two drive circuits. Therefore, in the composite sensor 6 having the circuit with the related-art configuration, there is a problem that it is difficult to miniaturize the device and to reduce the current consumption.

In contrast, in the composite sensor 1 according to the present embodiment, the drive circuit 20 for supplying the angular velocity sensor element 100 with the first signal (the drive signal) supplies the acceleration sensor element 200 with the first signal (the drive signal) as the second signal (the detecting drive signal). Therefore, in the composite sensor 1, the second drive circuit 70 for generating the second signal can be made unnecessary. Thus, the miniaturization of the circuit and the reduction in current consumption in the composite sensor 1 becomes possible. Further, due to the miniaturization (reduction in circuit area) of the circuit, reduction in cost of the composite sensor 1 also becomes possible. Further, since the drive circuit 20 is used in common, synchronization between the drive circuit 20 and the angular velocity sensor element 100 (the first functional element), and synchronization between the drive circuit 20 and the acceleration sensor element 200 (the second functional element) can easily be achieved.

It should be noted that although in the present embodiment, it is assumed that the same signal (the first signal) as the drive signal of the angular velocity sensor element 100 is supplied to the acceleration sensor element 200 as the detecting drive signal (the second signal), the second signal can also be a signal different from the first signal. For example, the frequency of the second signal can be different from the frequency of the first signal. For example, it is also possible to supply the acceleration sensor element 200 with a different signal, which is generated in the process of generating the first signal in the drive circuit 20, as the second signal.

### Second Embodiment

### Basic Configuration of Electronic Device

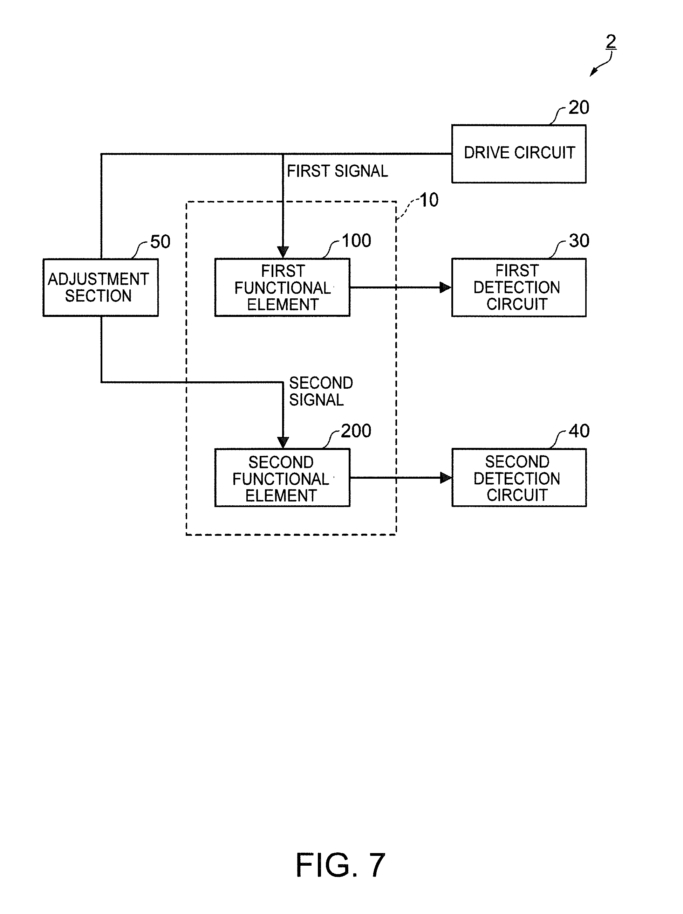

The basic configuration of a composite sensor as an electronic device according to a second embodiment will be explained with reference to Fig. 7. Fig. 7 is a block diagram showing a schematic configuration of the composite sensor according to the second embodiment. The composite sensor according to the second embodiment has substantially the same configuration as the configuration in the first embodiment except the point that an adjustment section is further provided. Here, the difference from the first embodiment will be explained. The constituents common to the first embodiment and the present embodiment are denoted with the same reference symbols, and the explanation thereof will be omitted.

As shown in Fig. 7, the composite sensor 2 according to the second embodiment is provided with the sensor element section 10, the drive circuit 20, the first detection circuit 30, the second detection circuit 40, and the adjustment section 50. The adjustment section 50 is disposed between the drive circuit 20 and the acceleration sensor element 200. The adjustment section 50 adjusts the first signal (the drive signal), which is supplied from the drive circuit 20 to the angular velocity sensor element 100, to form the second signal (the detecting drive signal) suitable for the acceleration sensor element 200.

The composite sensor 2 is provided with, for example, at least one of a frequency divider and a frequency multiplier which adjust the frequency of the drive signal as the adjustment section 50. According to such a configuration, the frequency of the first signal supplied from the drive circuit 20 can be adjusted (increased or decreased) using the adjustment section 50. Therefore, in the case in which, for example, the first signal has a frequency, which might incur the resonance the of the vibrating body 230 (the movable section 233) in the acceleration sensor element 200, the second signal, which has a frequency different from that of the first signal, can be supplied to the acceleration sensor element 200. Therefore, the resonance of the vibrating body 230 in the acceleration sensor element 200 can effectively be suppressed.

Further, the composite sensor 2 can also be provided with, for example, an amplitude adjustment section as the adjustment section 50. According to such a configuration, in the case in which, for example, the amplitude of the first signal supplied from the drive circuit 20 is insufficient as the amplitude of the second signal, it is possible to adjust (amplify) the amplitude to thereby supply the acceleration sensor element 200 with a suitable second signal. Therefore, the detection accuracy of the acceleration in the acceleration sensor element 200 can be improved.

It should be noted that the composite sensor 2 can be provided with a configuration in which the frequency divider, the frequency multiplier, and the amplitude adjustment section as the adjustment section 50. By adopting such a configuration, it is possible to adjust the frequency and the amplitude of the first signal (the drive signal) supplied from the drive circuit 20 to make the second signal (the detecting drive signal) more suitable for the acceleration sensor element 200.

### Third Embodiment

### Basic Configuration of Electronic Device

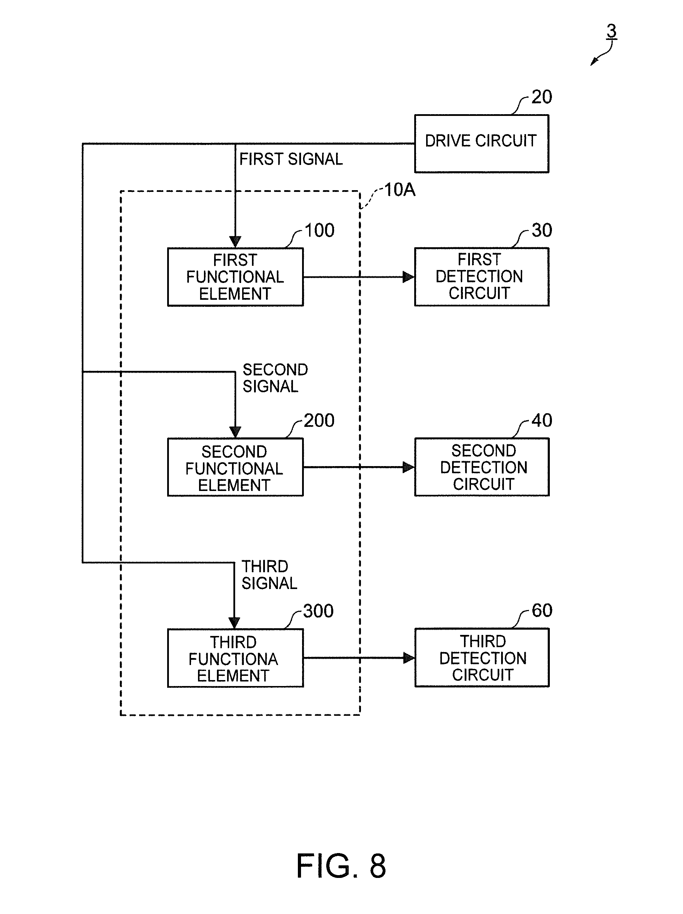

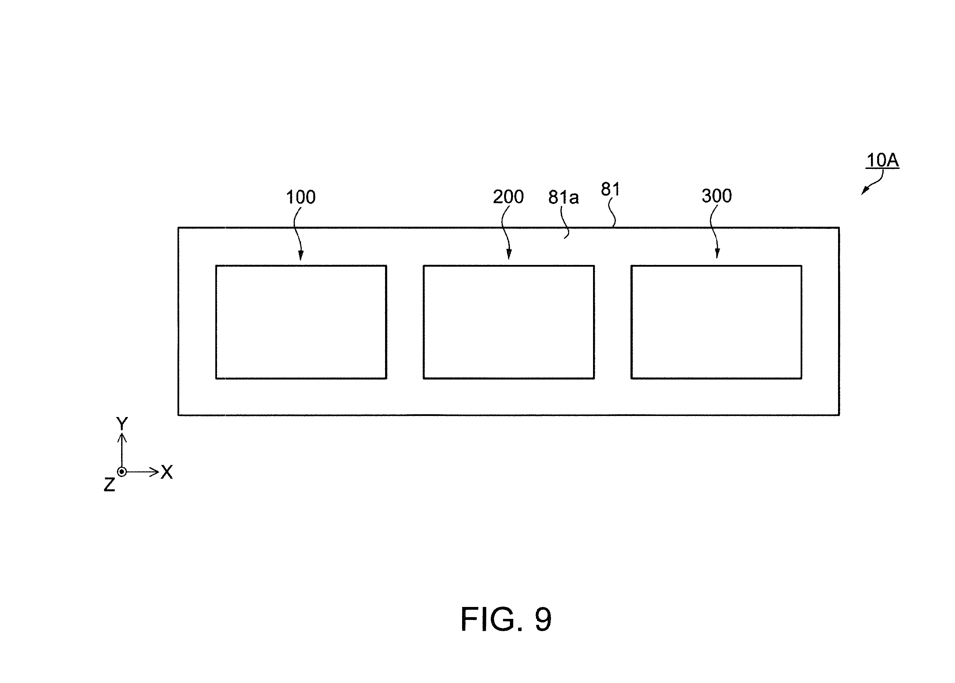

The basic configuration of a composite sensor as an electronic device according to a third embodiment will be explained with reference to Figs. 8 and 9. Fig. 8 is a block diagram showing a schematic configuration of the composite sensor according to the third embodiment. The composite sensor according to the third embodiment has substantially the same configuration as the configuration in the first embodiment except the point that a third functional element and a third detection circuit are further provided. Here, the difference from the first embodiment will be explained. The constituents common to the first embodiment and the present embodiment are denoted with the same reference symbols, and the explanation thereof will be omitted.

As shown in Fig. 8, the composite sensor 3 according to the third embodiment is provided with a sensor element section 10A, the drive circuit 20, the first detection circuit 30, the second detection circuit 40, and a third detection circuit 60. The sensor element section 10A according to the third embodiment includes the angular velocity sensor element 100 as the first functional element, the acceleration sensor element 200 as the second functional element, and a pressure sensor element 300 as a third functional element.

The drive circuit 20 supplies the angular velocity sensor element 100 with the first signal (the drive signal), supplies the acceleration sensor element 200 with the second signal (the detecting drive signal), and supplies the pressure sensor element 300 with a third signal (a detecting drive signal). In other words, in the composite sensor 3, the single drive circuit 20 is used in common to the three functional elements, namely the angular velocity sensor element 100, the acceleration sensor element 200, and the pressure sensor element 300.

The third signal supplied to the pressure sensor element 300 is supplied based on at least one of the first signal and the second signal. When external pressure (pressure) is applied, the pressure sensor element 300 outputs a detection signal based on a variation in capacitance to the third detection circuit 60.

Fig. 9 is a plan view schematically showing a sensor element section of the composite sensor according to the third embodiment. As shown in Fig. 9, the sensor element section 10A according to the third embodiment is provided with a substrate 81, the angular velocity sensor element 100, the acceleration sensor element 200, and the pressure sensor element 300. The angular velocity sensor element 100, the acceleration sensor element 200, and the pressure sensor element 300 are disposed on a first surface 81a side of the substrate 81.

Although in the example shown in Fig. 9, the angular velocity sensor element 100, the acceleration sensor element 200, and the pressure sensor element 300 are arranged side by side along the X-axis direction in the planar view, the direction in which the angular velocity sensor element 100, the acceleration sensor element 200, and the pressure sensor element 300 are arranged is not particularly limited, but it is possible for the angular velocity sensor element 100, the acceleration sensor element 200, and the pressure sensor element 300 to be arranged side by side along the Y-axis direction.

As the pressure sensor element 300, for example, any known pressure sensor elements can be used as long as the pressure sensor element is a type of detecting the pressure variation based on the electrical capacitance variation caused by the distance between a movable electrode disposed to a movable body and a stationary electrode varying due to the external pressure (pressure) such as the atmospheric pressure.

It should be noted that in the composite sensor 3 according to the third embodiment shown in Fig. 8, it is also possible to adopt a configuration of providing the adjustment section 50 according to the second embodiment to at least one of a path between the drive circuit 20 and the acceleration sensor element 200 and a path between the drive circuit 20 and the pressure sensor element 300. According to such a configuration, it is possible to adjust the frequency and the amplitude of the first signal (or the second signal) using the adjustment section 50 to supply the acceleration sensor element 200 with the suitable second signal, or to supply the pressure sensor element 300 with the suitable third signal.

Further, the composite sensor 3 can also be provided with another drive circuit in addition to the drive circuit 20. Specifically, it is also possible to adopt a configuration in which one drive circuit 20 is used in common to two functional elements out of the angular velocity sensor element 100, the acceleration sensor element 200, and the pressure sensor element 300, and another drive circuit than the drive circuit 20 is used with respect to the rest of the functional elements.

### Fourth Embodiment

### Electronic Apparatus

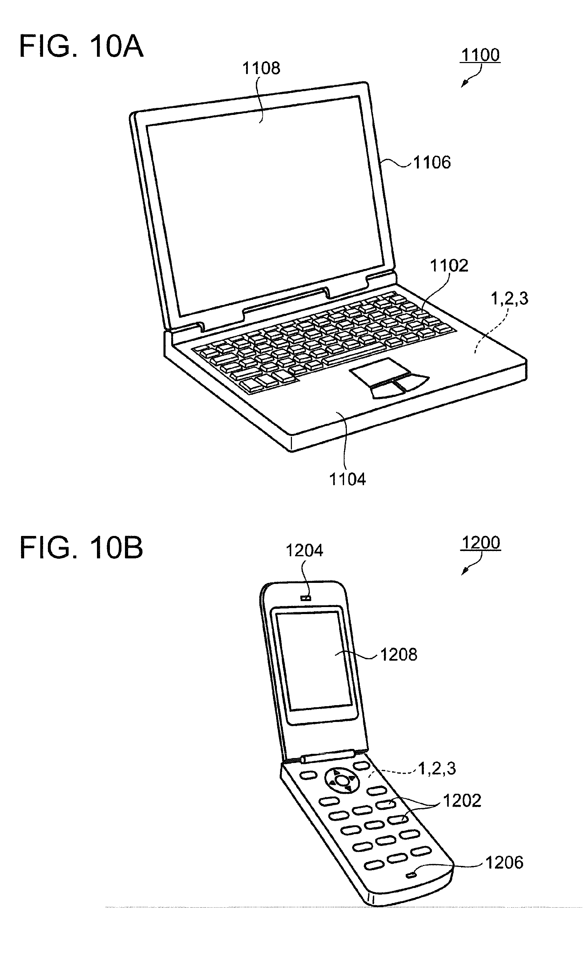

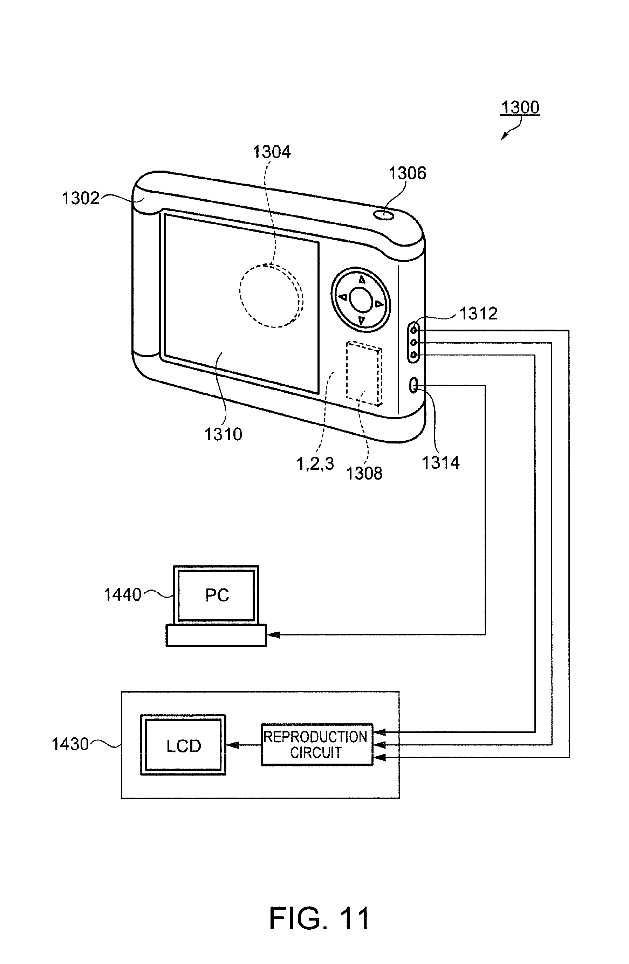

Then, some electronic apparatuses according to a fourth embodiment will be explained with reference to Figs. 10A, 10B, and 11. Figs. 10A, 10B, and 11 are each a perspective view schematically showing the electronic apparatus according to the fourth embodiment.

Fig. 10A shows a rough outline of a configuration of a mobile type (or a laptop type) personal computer as an example of the electronic apparatus according to the fourth embodiment. As shown in Fig. 10A, the personal computer 1100 is provided with a main body section 1104 provided with a keyboard 1102, and a display unit 1106 provided with a display section 1108. The display unit 1106 is rotatably supported with respect to the main body section 1104 via a hinge structure section. The personal computer 1100 incorporates either of the composite sensors 1, 2, and 3 according to the embodiments described above.

Fig. 10B shows an outline of a configuration of a cellular phone (including PHS) as an example of the electronic apparatus according to the fourth embodiment. As shown in Fig. 10B, the cellular phone 1200 is provided with a plurality of operation buttons 1202, an ear piece 1204, and a mouthpiece 1206, and a display section 1208 is disposed between the operation buttons 1202 and the ear piece 1204. The cellular phone 1200 incorporates either of the composite sensors 1, 2, and 3 according to the embodiments described above.

Fig. 11 shows a rough outline of a configuration of a digital still camera as an example of the electronic apparatus according to the fourth embodiment. It should be noted that the connection with external equipment is also shown briefly in this drawing. It should be noted that conventional cameras expose silver salt films to optical images of an object on the one hand, the digital still camera 1300 performs photoelectric conversion on the optical image of the object using an imaging element such as a CCD (charge coupled device) to generate an imaging signal (an image signal), on the other hand.

As shown in Fig. 11, the case (body) 1302 of the digital still camera 1300 is provided with a display section 1310 disposed on the back surface thereof to have a configuration of performing display in accordance with the imaging signal due to the CCD, wherein the display section 1310 functions as a viewfinder for displaying the object as an electronic image. Further, the front surface (the back side in the drawing) of the case 1302 is provided with a light receiving unit 1304 including an optical lens (an imaging optical system), the CCD, and so on.

When the photographer checks an object image displayed on the display section 1310, and then holds down a shutter button 1306, the imaging signal from the CCD at that moment is transferred to and stored in a memory device 1308. Further, the digital still camera 1300 is provided with video signal output terminals 1312 and an input-output terminal 1314 for data communication disposed on a side surface of the case 1302.

A television monitor 1430 and a personal computer 1440 are connected to the video signal output terminals 1312 and the input-output terminal 1314 for data communication, respectively, as needed. Further, there is adopted the configuration in which the imaging signal stored in the memory device 1308 is output to the television monitor 1430 and the personal computer 1440 in accordance with a predetermined operation. The digital still camera 1300 incorporates either of the composite sensors 1, 2, and 3 according to the embodiments described above.

It should be noted that, besides the personal computer 1100, the cellular phone 1200, and the digital still camera 1300 according to the fourth embodiment, the composite sensors 1, 2, and 3 can also be applied to electronic apparatuses such as an inkj et ejection device (e.g. , an inkj et printer), a laptop personal computer, a television set, a video camera, a video cassette recorder, a car navigation system, a pager, a personal digital assistance (including one with a communication function), an electronic dictionary, an electric calculator, a computerized game machine, a word processor, a workstation, a video phone, a security video monitor, a pair of electronic binoculars, a POS terminal, a medical device (e.g. , an electronic thermometer, an electronic manometer, an electronic blood sugar meter, an electrocardiogram measurement instrument, an ultrasonograph, and an electronic endoscope), a fish detector, a variety of types of measurement instruments, a variety of types of gauges (e.g., gauges for a vehicle, an aircraft, or a ship), and a flight simulator.

### Fifth Embodiment

### Moving Object

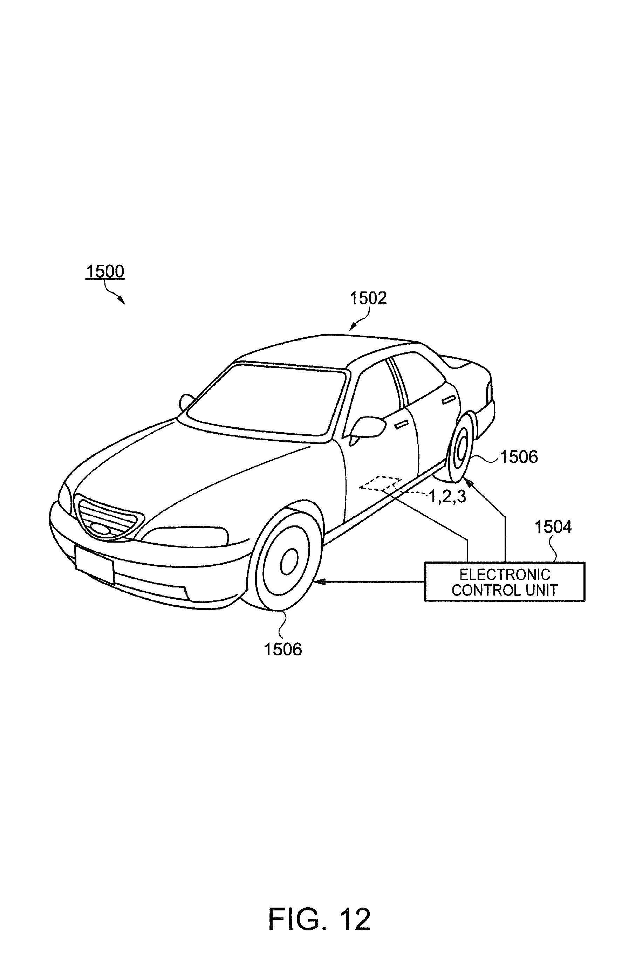

Then, a moving obj ect according to a fifth embodiment will be explained with reference to Fig. 12. Fig. 12 is a perspective view schematically showing the moving object according to the fifth embodiment.

Fig. 12 shows a rough outline of a configuration of a vehicle as an example of the moving object according to the fifth embodiment. As shown in Fig. 12, the vehicle 1500 is provided with a vehicle body 1502 and tires 1506, and an electronic control unit 1504 for controlling the tires 1506 and so on is installed in the vehicle body 1502. The electronic control unit 1504 incorporates either of the composite sensors 1, 2, and 3 according to the embodiments described above.

It should be noted that, besides the above, the composite sensors 1, 2, and 3 can be applied to an electronic control unit (ECU) such as a keyless entry system, an immobilizer, a car navigation system, a car air-conditioner, an anti-lock braking system (ABS), an air-bag system, a tire pressure monitoring system (TPMS), an engine controller, a battery monitor for a hybrid car or an electric car, or a vehicle attitude control system.

The embodiments described above are each only for showing an aspect of the invention, and can arbitrarily be modified or applied within the scope of the invention as defined by the appended claims. The following can be cited as such modified examples.

Although the composite sensors 1 and 2 according to the first embodiment and the second embodiment each have the configuration provided with the angular velocity sensor element 100 as the first functional element and the acceleration sensor element 200 as the second functional element, and the composite sensor 3 according to the third embodiment has the configuration further provided with the pressure sensor element 300 as the third functional element, the invention is not limited to such configurations. For example, it is also possible to adopt a configuration in which the composite sensors 1, 2, and 3 are each provided with either one of the angular velocity sensor element and the acceleration sensor element, and the first functional element, the second functional element, and the third functional element are different from each other in the direction of the angular velocity or the acceleration detected.

### Modified Example 1

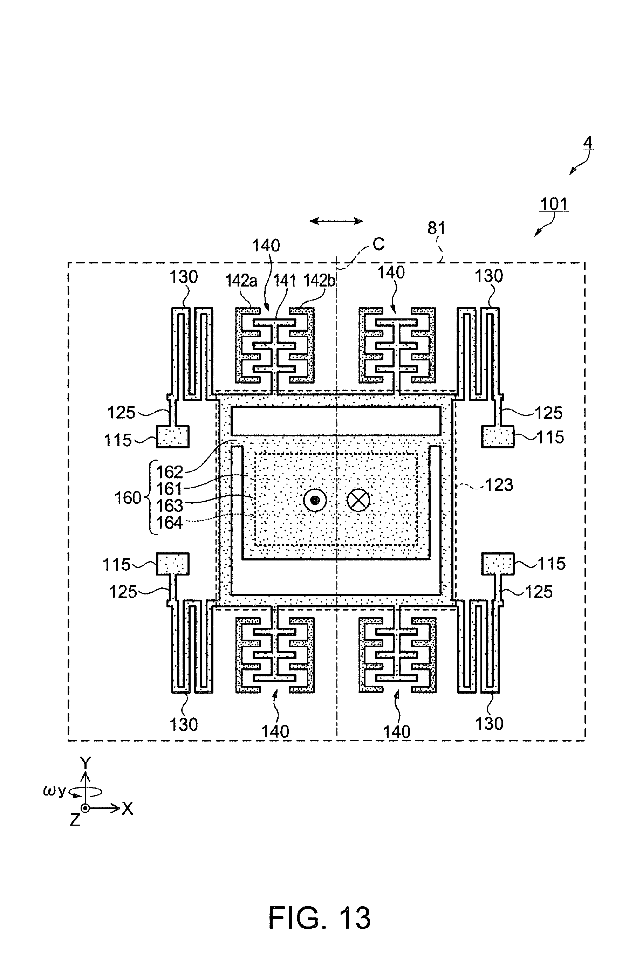

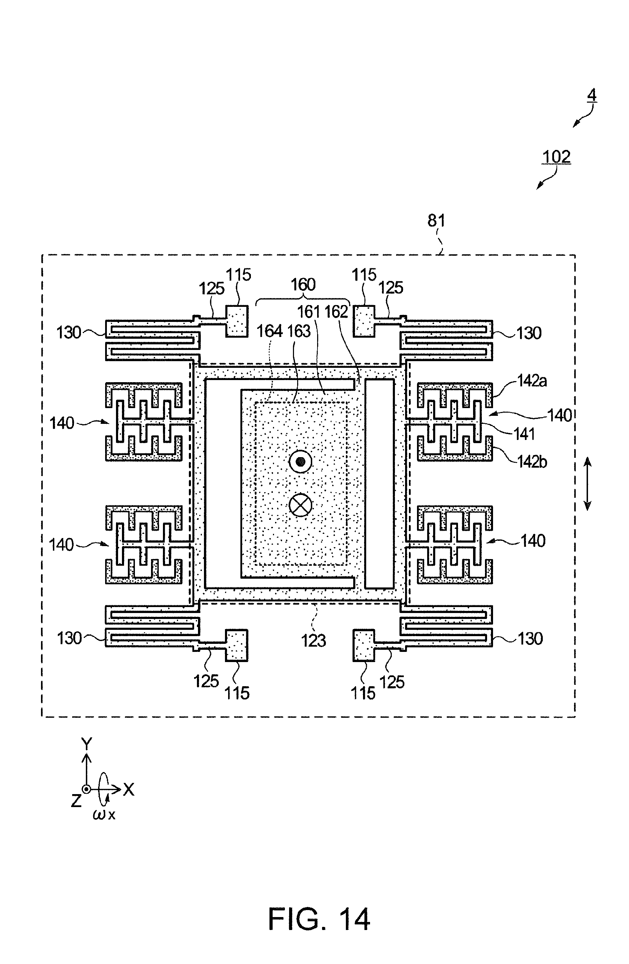

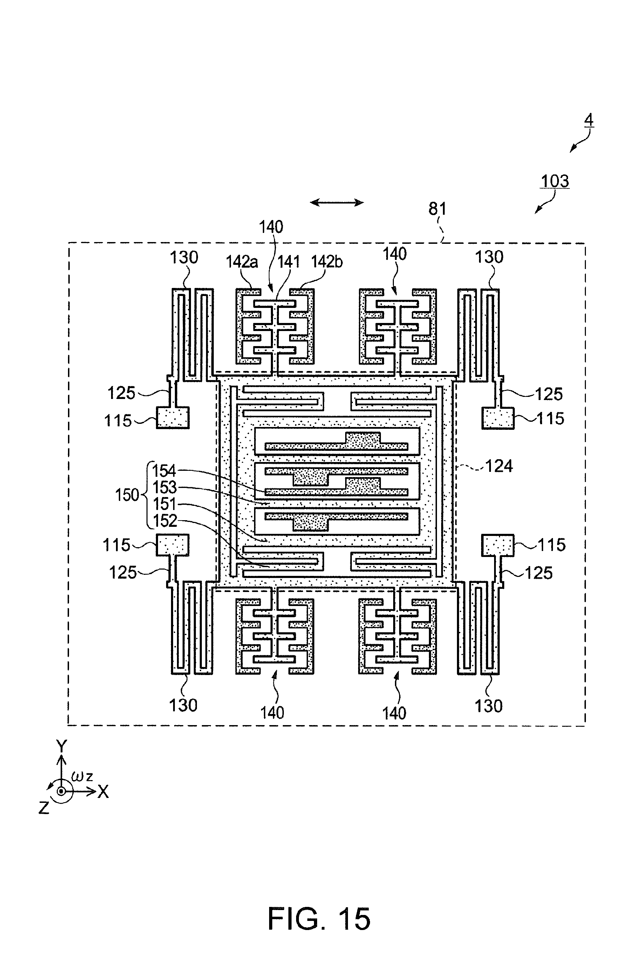

A composite sensor according to Modified Example 1 is the same as the composite sensor 3 according to the third embodiment shown in Figs. 8 and 9 in the point that the three functional elements are provided, but is different therefrom in the point that the angular velocity sensor elements for detecting the angular velocity around three respective axes different from each other are provided as the three functional elements. Fig. 13 is a schematic plan view showing a configuration of an angular velocity sensor element as the first functional element of the composite sensor according to Modified Example 1. Fig. 14 is a schematic plan view showing a configuration of an angular velocity sensor element as the second functional element of the composite sensor according to Modified Example 1. Fig. 15 is a schematic plan view showing a configuration of an angular velocity sensor element as the third functional element of the composite sensor according to Modified Example 1. The constituents common to the embodiments described above and the Modified Example 1 are denoted with the same reference symbols, and the explanation thereof will be omitted.

As shown in Figs. 13, 14, and 15, the composite sensor 4 according to Modified Example 1 is provided with the angular velocity sensor element 101 as the first functional element, the angular velocity sensor element 102 as the second functional element, and the angular velocity sensor element 103 as the third functional element. The angular velocity sensor element 101, the angular velocity sensor element 102, and the angular velocity sensor element 103 correspond respectively to the first functional element 100, the second functional element 200, and the third functional element 300 shown in Figs. 8 and 9.

As shown in Fig. 13, the angular velocity sensor element 101 is provided with a vibrating body 123, the beam sections 125, the fixation sections 115, the coupling sections 130, the drive sections 140, and a detection section 160. The vibrating body 123 has substantially the same configuration as that of the first vibrating section 121 (or the second vibrating section 122) of the angular velocity sensor element 100 shown in Fig. 3. The beam sections 125, the fixation sections 115, the coupling sections 130, and the drive sections 140 have substantially the same configurations as those in the angular velocity sensor element 100.

The vibrating body 123 has a roughly rectangular frame-like shape (a square shape) including parts extending in the X-axis direction and parts extending in the Y-axis direction in the planar view. The vibrating body 123 is connected to the coupling sections 130 at four points in the X-axis direction, and can vibrate in the X-axis direction due to the drive sections 140.

The detection section 160 is provided with a movable body 161, a beam section 162, a detecting movable electrode 163, and a detecting stationary electrode 164. The detection section 160 is disposed inside the vibrating body 123. The movable body 161 has a plate-like shape, and is supported by the vibrating body 123 via the beam section 162. The movable body 161 is coupled to the side surface (the side surface having a perpendicular line parallel to the X axis) in the X-axis direction of the vibrating body 123 with the beam section 162 forming a rotary shaft.

The beam section 162 is disposed along the X axis at a position shifted from the centroid of the movable body 161. The beam section 162 can torsionally be deformed, and can displace the movable body 161 in the Z-axis direction due to the torsional deformation. Although in the example shown in Fig. 13, the movable body 161 extends from the beam section 162 in the -Y direction, the extending direction of the movable body 161 is not particularly limited.

The detecting movable electrode section 163 is provided to the movable body 161. In the example shown in Fig. 13, the detecting movable electrode section 163 is a part of the movable body 161 overlapping the detecting stationary electrode section 164 in the planar view. The detecting movable electrode section 163 is a part of the movable body 161 forming a capacitance with the detecting stationary electrode section 164.

The detecting stationary electrode section 164 is fixed to the substrate 81, and is disposed so as to be opposed to the detecting movable electrode section 163. The detecting stationary electrode section 164 is disposed on, for example, a bottom surface (not shown) of a recessed section disposed to the substrate 81 in a similar manner to the recessed section 14 (see Fig. 2B) of the substrate 11. In the example shown in Fig. 13, the planar shape of the detecting stationary electrode section 164 is a rectangle.

In the angular velocity sensor element 101, when the drive signal is applied to the drive section 140, the coupling sections 130 expand and contract in the X-axis direction due to the electrostatic force generated between the driving movable electrode sections 141 and the driving stationary electrode sections 142a, 142b, and thus, the vibrating body 123 vibrates in the X-axis direction. Due to the vibration of the vibrating body 123, the movable body 161 supported by the vibrating body 123 via the beam section 162 also vibrates in the X-axis direction.

When an angular velocity ωy around the Y axis is applied to the angular velocity sensor element 101 in the state in which the vibrating body 123 vibrates in the X-axis direction, a Coriolis force acts, and the movable body 161 is displaced in the Z-axis direction. By the movable body 161 being displaced in the Z-axis direction, the detecting movable electrode section 163 gets closer to or away from the detecting stationary electrode section 164, and therefore, the capacitance between the detecting movable electrode section 163 and the detecting stationary electrode section 164 varies. By detecting the variation of the capacitance between the detecting movable electrode section 163 and the detecting stationary electrode section 164, the angular velocity ωy around the Y axis can be detected.

As shown in Fig. 14, the angular velocity sensor element 102 is provided with the vibrating body 123, the beam sections 125, the fixation sections 115, the coupling sections 130, the drive sections 140, and the detection section 160. The angular velocity sensor element 102 has a configuration obtained by rotating the angular velocity sensor element 101 shown in Fig. 13 as much as 90 degrees using the Z axis as a rotational axis. Therefore, the detailed explanation of the configuration of the angular velocity sensor element 102 will be omitted.

In the angular velocity sensor element 102, the vibrating body 123 vibrates in the Y-axis direction, and when an angular velocity ωx around the X axis is applied in the state in which the vibrating body 123 vibrates in the Y-axis direction, a Coriolis force acts, and the movable body 161 is displaced in the Z-axis direction. By detecting the variation of the capacitance between the detecting movable electrode section 163 and the detecting stationary electrode section 164 due to this displacement, the angular velocity ωx around the X axis can be detected.

As shown in Fig. 15, the angular velocity sensor element 103 is provided with a vibrating body 124, the beam sections 125, the fixation sections 115, the coupling sections 130, the drive sections 140, and the detection section 150. The angular velocity sensor element 103 is a part corresponding to the first structure 100a (or the second structure 100b) of the angular velocity sensor element 100 shown in Fig. 3. The vibrating body 124 has substantially the same configuration as that of the first vibrating section 121 (or the second vibrating section 122) of the vibrating body 120 of the angular velocity sensor element 100. In the angular velocity sensor element 103 , the vibrating body 124 is connected to the coupling sections 130 at four points in the X-axis direction.

In the angular velocity sensor element 103, the vibrating body 124 vibrates in the X-axis direction, and when an angular velocity ωz around the Z axis is applied in the state in which the vibrating body 124 vibrates in the X-axis direction, a Coriolis force acts, and the detection section 150 is displaced in the Y-axis direction. By detecting the variation of the capacitance between the detecting movable electrode section 153 and the detecting stationary electrode section 154 due to this displacement, the angular velocity ωz around the Z axis can be detected.

As described above, in the composite sensor 4 according to Modified Example 1, by providing the angular velocity sensor element 101, the angular velocity sensor element 102, and the angular velocity sensor element 103, the angular velocities around the respective three axes (the Y axis, the X axis, and the Z axis) perpendicular to each other can be detected.

It should be noted that it is also possible to adopt a configuration in which the composite sensor 4 is provided with an angular velocity sensor element having a pair of angular velocity sensor elements 101 coupled to each other as the first functional element, an angular velocity sensor element having a pair of angular velocity sensor elements 102 coupled to each other as the second functional element, and the angular velocity sensor element 100 (see Fig. 3) according to the first embodiment as the third functional element. By providing such a configuration to the composite sensor 4, the detection accuracy of the angular velocities ωx, ωy, and ωz around the respective axes can be improved.

Further, the first signal, the second signal, and the third signal supplied from the drive circuit 20 (see Fig. 8) of the composite sensor 4 respectively to the angular velocity sensor element 101, the angular velocity sensor element 102, and the angular velocity sensor element 103 can be the same signal, or signals different in frequency or the amplitude from each other.

### Modified Example 2

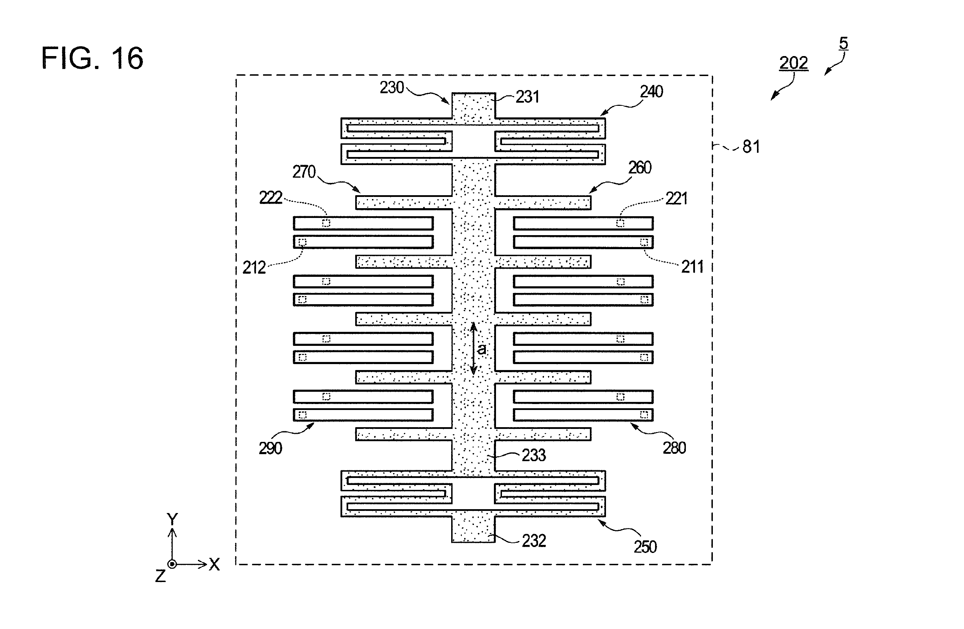

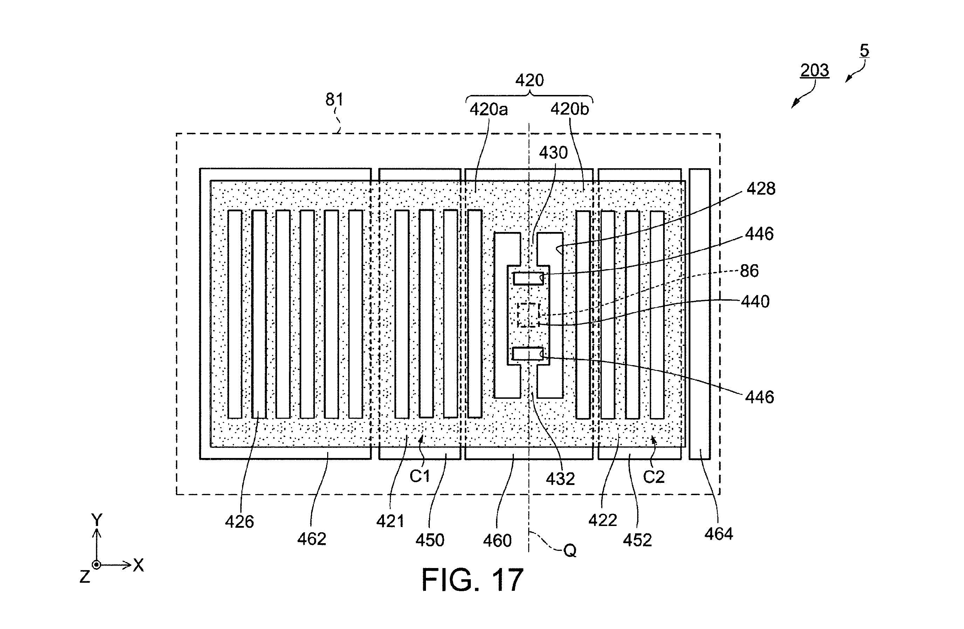

A composite sensor according to Modified Example 2 is the same as the composite sensor 3 according to the third embodiment in the point that the three functional elements are provided, but is different therefrom in the point that the acceleration sensor elements for detecting the acceleration in three respective axis directions different from each other are provided as the three functional elements. Fig. 16 is a schematic plan view showing a configuration of an acceleration sensor element as the second functional element of the composite sensor according to Modified Example 2. Fig. 17 is a schematic plan view showing a configuration of an acceleration sensor element as the third functional element of the composite sensor according to Modified Example 2. The constituents common to the embodiments described above and the Modified Example 1 are denoted with the same reference symbols, and the explanation thereof will be omitted. It should be noted that it is assumed that the first functional element of the composite sensor according to Modified Example 2 has roughly the same configuration as that of the acceleration sensor element 200 shown in Fig. 5.

As shown in Figs. 5, 16, and 17, the composite sensor 5 according to Modified Example 2 is provided with the acceleration sensor element 200 as the first functional element, the acceleration sensor element 202 as the second functional element, and the acceleration sensor element 203 as the third functional element. The acceleration sensor element 200 is capable of detecting the acceleration in the X-axis direction.

As shown in Fig. 16, the acceleration sensor element 202 is provided with the vibrating body 230, a stationary electrode section 280, and a stationary electrode section 290. The acceleration sensor element 202 has a configuration obtained by rotating the acceleration sensor element 200 shown in Fig. 5 as much as 90 degrees using the Z axis as a rotational axis. Therefore, the detailed explanation of the configuration of the acceleration sensor element 202 will be omitted.

In the acceleration sensor element 202, when the acceleration in the Y-axis direction is applied, the vibrating body 230 (the movable section 233) is displaced in the Y-axis direction in accordance with the acceleration applied. By measuring the variation of the capacitance between the movable electrode sections 260, 270 and the first stationary electrode fingers and the second stationary electrode fingers of the stationary electrode sections 280, 290 due to the vibration of the vibrating body 230, the acceleration in the Y-axis direction can be detected.

As shown in Fig. 17, the acceleration sensor element 203 is provided with a vibrating body 420, support sections 430, 432, a fixation section 440, stationary electrode sections 450, 452, and guard electrode sections 460, 462, and 464.

The vibrating body 420 includes a first part 420a and a second part 420b. The planar shape of the vibrating body 420 is, for example, a rectangle. The vibrating body 420 is zoned into the first part 420a and the second part 420b using a support axis Q as a boundary line in the planar view. The support axis Q is an axis determined by the support sections 430, 432, and parallel to the Y-axis direction. When the acceleration in the Z-axis direction is applied, the vibrating body 420 makes seesaw oscillation using the support axis Q as a rotational axis (an oscillation axis). The vibrating body 420 is provided with a plurality of slit sections (through holes) 426 in order to reduce an influence of air (friction of air) when the vibrating body 420 oscillates.

The support axis Q is disposed at a position shifted from the center (centroid) of the vibrating body 420. Therefore, in the vibrating body 420, the mass of the first part 420a and the mass of the second part 420b are different from each other. Thus, when the acceleration in the Z-axis direction is applied, since the rotational moment of the first part 420a and the rotational moment of the second part 420b do not balance with each other, a predetermined tilt occurs in the vibrating body 420. It should be noted that it is also possible to dispose the support axis Q at the center (centroid) of the vibrating body 420, and make the thickness of the first part 420a and the thickness of the second part 420b different from each other to thereby make the mass of the first part 420a and the mass of the second part 420b different from each other.

The vibrating body 420 is provided with an opening section 428 disposed between the first part 420a and the second part 420b. In the opening section 428, there are disposed the support sections 430, 432, and the fixation section 440 so as to overlap the support axis Q in the planar view. The vibrating body 420 is connected to the fixation section 440 via the support sections 430, 432. The support sections 430, 432 support the vibrating body 420 so as to be able to be displaced around the support axis Q, and functions as a torsional spring. Thus, since the vibrating body 420 makes the seesaw oscillation, a strong restorative force to the torsional deformation caused in the support sections 430, 432 is obtained.

The fixation section 440 is disposed so as to overlap the support axis Q in the planar view. The fixation section 440 is bonded to a post section 86 of the substrate 81. The post section 86 is a part projecting from the bottom surface (not shown) of the recessed section disposed to the substrate 81 in a similar manner to the recessed section 14 (see Fig. 2B) of the substrate 11 as much as the depth of the recessed section. The fixation section 440 is provided with a through hole 446 disposed so as to overlap the support axis Q in the planar view. By providing the through hole 446 to the fixation section 440, it is possible to reduce an influence exerted on the support sections 430, 432 by the stress or the like caused by the difference in thermal expansion coefficient between the substrate 81 and the vibrating body 420.

The guard electrode sections 460, 462, and 464 are disposed on the bottom surface of the recessed section provided to the substrate 81. The guard electrode section 460 is disposed so as to overlap the support sections 430, 432 and the fixation section 440 in the planar view. The guard electrode section 462 is disposed so as to overlap the first part 420a in the planar view, and the guard electrode section 464 is disposed on the +X side of the second part 420b. The guard electrode sections 460, 462, and 464 are electrically connected to the vibrating body 420 (a movable electrode section 421 and a movable electrode section 422) via a wiring section and so on. Thus, since the guard electrode sections 460, 462, and 464 and the vibrating body 420 become equipotential to each other, the electrostatic force acting between the vibrating body 420 or the support sections 430, 432 and the substrate 81 can be suppressed.

The stationary electrode sections 450, 452 are disposed on the bottom surface of the recessed section provided to the substrate 81. The stationary electrode section 450 is disposed on the first part 420a side, and is arranged between the guard electrode section 460 and the guard electrode section 462. The stationary electrode section 452 is disposed on the second part 420b side, and is arranged between the guard electrode section 460 and the guard electrode section 464. The area of the part of the stationary electrode section 450 opposed to the vibrating body 420 and the area of the stationary electrode section 452 opposed to the vibrating body 420 are equal to each other. The planar shape of the stationary electrode section 450 and the planar shape of the stationary electrode section 452 are symmetrical to each other about the support axis Q.

The vibrating body 420 is provided with the movable electrode section 421 disposed in the first part 420a and the movable electrode section 422 disposed in the second part 420b divided by the support axis Q as the boundary. In the planar view, the movable electrode section 421 overlaps the stationary electrode section 450, and the movable electrode section 422 overlaps the stationary electrode section 452. The capacitance C1 is formed between the movable electrode section 421 and the stationary electrode section 450, and the capacitance C2 is formed between the movable electrode section 422 and the stationary electrode section 452. The capacitance C1 and the capacitance C2 are configured so as to be equal to each other in the case in which, for example, the vibrating body 420 is in a horizontal state. The movable electrode sections 421, 422 vary in position in accordance with the movement of the vibrating body 420. The capacitances C1, C2 vary in accordance with the positions of the movable electrode sections 421, 422.

In the acceleration sensor element 203, when the acceleration is applied, the vibrating body 420 oscillates around the support axis Q. Due to the movement of the vibrating body 420, the distance between the movable electrode section 421 and the stationary electrode section 450 and the distance between the movable electrode section 422 and the stationary electrode section 452 vary. For example, when the acceleration in the +Z direction is applied, the vibrating body 420 rotates counterclockwise, the distance between the movable electrode section 421 and the stationary electrode section 450 decreases, and the distance between the movable electrode section 422 and the stationary electrode section 452 increases. As a result, the capacitance C1 increases, and the capacitance C2 decreases.

Further, when the acceleration in the -Z direction is applied, the vibrating body 420 rotates clockwise, the distance between the movable electrode section 421 and the stationary electrode section 450 increases, and the distance between the movable electrode section 422 and the stationary electrode section 452 decreases. As a result, the capacitance C1 decreases, and the capacitance C2 increases. As described above, in the acceleration sensor element 203, the acceleration in the Z-axis direction can be detected based on the difference between the capacitance C1 and the capacitance C2.

It should be noted that although in Modified Example 1 and Modified Example 2, there is adopted the configuration in which the composite sensors 4, 5 are each provided with either one of the angular velocity sensor element and the acceleration sensor element as the three functional elements, namely the first functional element, the second functional element, and the third functional element, it is also possible to adopt a configuration in which the composite sensor is provided with the angular velocity sensor element and the acceleration sensor element in combination with each other.

Further, although in the embodiments and the modified examples described above, the electronic device is the composite sensor provided with the sensor elements such as the angular velocity sensor element, the acceleration sensor element, or the pressure sensor element as the functional elements, the configuration of the electronic device is not limited to such a configuration. It is possible for the electronic device to have a configuration provided with either of these sensor elements and a functional element other than the sensor elements.

## Claims

1. An electronic device (1, 2, ..., 5) comprising:
a first functional element (100, 101);
a second functional element (200, 202); and
a signal generation section (20) adapted to generate a first signal used to excite the first functional element (100, 101),
wherein the signal generation section (20) supplies the second functional element (200, 202) with a second signal based on the first signal.

2. The electronic device (2, ..., 5) according to Claim 1, further comprising an adjustment section (50) adapted to adjust the first signal to form the second signal and disposed between the signal generation section (20) and the second functional element (200, 202).

3. The electronic device (2, ..., 5) according to Claim 2, wherein the adjustment section (50) includes at least one of a frequency multiplier and a frequency divider adapted to adjust a frequency of the first signal.

4. The electronic device (2, ..., 5) according to Claim 2 or 3, wherein the adjustment section (50) includes an amplitude adjustment section adapted to adjust an amplitude of the first signal.

5. The electronic device (1, 2, ..., 5) according to any one of the preceding Claims, in which the electronic device (1, 2, ..., 5) is a composite sensor.

6. The electronic device (1, 2, 3) according to any one of the preceding Claims, wherein
the first functional element (100, 101) is an angular velocity sensor element, and
the second functional element (200, 202) is an acceleration sensor element.

7. The electronic device (1, 2, 3) according to any one of the preceding Claims, wherein the second signal is different in frequency from the first signal.

8. The electronic device (1, 2, 3) according to any one of the preceding Claims, wherein the first signal is a sinusoidal wave.

9. The electronic device (3, 4, 5) according to any one of the preceding Claims, further comprising a third functional element (100, 103, 203, 300), wherein the third functional element (100, 103, 203, 300) is supplied with a third signal based on at least one of the first signal and the second signal.

10. The electronic device (3) according to Claim 9, wherein
the first functional element is an angular velocity sensor element (100),
the second functional element is an acceleration sensor element (200), and
the third functional element is a pressure sensor (300).

11. The electronic device (4) according to Claim 9, wherein the first (101), second (102) and third functional elements (103) are angular velocity sensors.

12. The electronic device (4) according to Claim 9, wherein
the first functional element is an angular velocity sensor element having a pair of angular velocity sensor elements (101) coupled to each other,
the second functional element is an angular velocity sensor element having a pair of angular velocity sensor elements (102) coupled to each other, and
the third functional element is an angular velocity sensor element (100).

13. The electronic device (5) according to Claim 9, wherein the first (200), second (202) and third functional elements (203) are acceleration sensors.

14. An electronic apparatus (1100, 1200, 1300) comprising the electronic device (1, 2, ..., 5) according to any one of the preceding Claims.

15. A moving object such as a vehicle (1500) comprising the electronic device (1, 2, ..., 5) according to any one of the preceding Claims.
